# EUROPEAN PATENT APPLICATION

(11) **EP 3 975 414 A1**
(43) Date of publication of application: **30.03.2022**
(21) Application number: 20809597.6
(22) Date of filing: 13.04.2020
(51) Int. Cl.: H02N 11/00, H01L 37/00

(54) **POWER GENERATION ELEMENT, POWER GENERATION DEVICE, ELECTRONIC APPARATUS, AND MANUFACTURING METHOD FOR POWER GENERATION ELEMENT**

(30) Priority: 21.05.2019 JP 2019095567
(71) Applicant: GCE Institute Inc., Tokyo 104-0061 (JP)
(72) Inventor: GOTO, Hiroshi, Tokyo 104-0061 (JP); SAKATA, Minoru, Tokyo 104-0061 (JP)
(74) Representative: Rings, Rolf
(86) International application number: PCT/JP2020/016263
(87) International publication number: WO 2020/235254

(57) **Abstract**

[Problem]

Provided is a power generation element, a power generation device, and an electronic apparatus that allow to achieve stabilizing a generation amount of an electric energy, and a method for manufacturing the power generation element.

[Solution]

A power generation element includes: a substrate 10 including mutually opposed first principal surface 11s and second principal surface 12s; an electrode portion 13 provided on the first principal surface 11s and the second principal surface 12s, the electrode portion 13 including a first electrode portion 13a and a second electrode portion 13b; and an intermediate portion 14 including nanoparticles. The substrate 10 includes a first substrate portion 11 and a second substrate portion 12 that are mutually overlapped viewed in a first direction Z. The first principal surface 11s of the first substrate portion 11 includes a first separated surface 11sa and a first joint surface 11sb. The second principal surface 12s of the second substrate portion 12 includes a second separated surface 12sa and a second joint surface 12sb.

## Description

### TECHNICAL FIELD

The present invention relates to a power generation element that converts a thermal energy into an electric energy, a power generation device, an electronic apparatus, and a method for manufacturing the power generation element.

### BACKGROUND ART

Recently, a power generation element, such as a thermoelectric element that uses a thermal energy to generate an electric energy, has been actively developed. Patent Documents 1, 2 disclose thermoelectric elements that use electron emission phenomena using absolute temperature that occur between electrodes having work function differences. These thermoelectric elements can perform electric generation even when a temperature difference between electrodes is small compared with a thermoelectric element that uses a temperature difference between electrodes (Seebeck effect). Therefore, application for wider use has been expected.

Patent Document 1 discloses a thermoelectric element that includes an emitter electrode layer, a collector electrode layer, and electrically insulating spherical nanobeads that are dispersedly arranged on surfaces of the emitter electrode layer and the collector electrode layer and separate the emitter electrode layer and the collector electrode layer at submicron intervals. A work function of the emitter electrode layer is smaller than a work function of the collector electrode layer. Particle diameters of the spherical nanobeads are 100 nm or less.

Patent Document 2 discloses a nanofluid contact potential difference battery that includes an anode with a higher work function and a cathode with a lower work function separated by a nanometer-scale spaced interelectrode gap. The nanofluid is provided in the interelectrode gap.

Patent Document 1: Japanese Patent No. 6147901
Patent Document 2: US Patent Application Publication No. 2015-0229013

### DISCLOSURE OF THE INVENTION

### PROBLEMS TO BE SOLVED BY THE INVENTION

In the thermoelectric elements using the above-described techniques disclosed in Patent Documents 1, 2, and the like, it is premised that a supporting member such as spherical nanobeads is used when an interelectrode gap is formed. Therefore, a variation of the interelectrode gap caused by variations in shape and thickness of the supporting member increases. Accordingly, there is a concern that a generation amount of the electric energy becomes unstable.

Therefore, the present invention has been made in consideration of the above-described circumstance, and has an object to provide a power generation element, a power generation device, and an electronic apparatus that can achieve stabilization of an electric energy generation amount, and a method for manufacturing the power generation element.

### SOLUTIONS TO THE PROBLEMS

A power generation element according to the first invention is a power generation element that converts a thermal energy into an electric energy. The power generation element includes a substrate, an electrode portion, and an intermediate portion. The substrate includes mutually opposed first principal surface and second principal surface. The electrode portion is provided on the first principal surface and the second principal surface. The electrode portion includes a first electrode portion and a second electrode portion. The second electrode portion has a work function different from a work function of the first electrode portion. The intermediate portion includes nanoparticles having a work function between the work function of the first electrode portion and the work function of the second electrode portion. The substrate includes a first substrate portion and a second substrate portion that are mutually overlapped viewed in a first direction intersecting with the first principal surface and the second principal surface. The intermediate portion is sandwiched between the first electrode portion provided on the first principal surface of the first substrate portion and the second electrode portion provided on the second principal surface of the second substrate portion. The first principal surface of the first substrate portion includes a first separated surface and a first joint surface. The first separated surface is in contact with the first electrode portion provided on the first substrate portion and separated from the second substrate portion. The first joint surface is provided to be continuous with the first separated surface, separated from the first electrode portion provided on the first substrate portion, and in contact with the second substrate portion. The second principal surface of the second substrate portion includes a second separated surface and a second joint surface. The second separated surface is in contact with the second electrode portion provided on the second substrate portion and separated from the first substrate portion. The second joint surface is provided to be continuous with the second separated surface, separated from the second electrode portion provided on the second substrate portion, and in contact with the first substrate portion.

In the power generation element according to the second invention, in the first invention, the first electrode portions are provided on the first principal surface of the first substrate portion and the first principal surface of the second substrate portion, and the second electrode portions are provided on the second principal surface of the first substrate portion and the second principal surface of the second substrate portion.

In the power generation element according to the third invention, in the first invention, the first electrode portions are provided on the first principal surface and the second principal surface of the first substrate portion, and the second electrode portions are provided on the first principal surface and the second principal surface of the second substrate portion.

In the power generation element according to the fourth invention, in any of the first invention to the third invention, the intermediate portion is surrounded by the first joint surface and the second joint surface viewed in the first direction.

The power generation element according to the fifth invention, in any of the first invention to the fourth invention, further includes a first connection wiring and a second connection wiring that are provided on side surfaces of the substrate and mutually opposed. The first connection wiring is in contact with the first electrode portion provided on the first substrate portion and the first electrode portion provided on the second substrate portion. The second connection wiring is in contact with the second electrode portion provided on the first substrate portion and the second electrode portion provided on the second substrate portion.

In the power generation element according to the sixth invention, in the fifth invention, a plurality of the first substrate portions and a plurality of the second substrate portions are stacked in the first direction, the first connection wiring extends in the first direction and is in contact with the plurality of first electrode portions, and the second connection wiring extends in the first direction and is in contact with the plurality of second electrode portions.

In the power generation element according to the seventh invention, in any of the first invention to the sixth invention, a side surface of the first electrode portion provided on the first substrate portion and a side surface of the second electrode portion provided on the second substrate portion are in contact with the intermediate portion.

In the power generation element according to the eighth invention, in any of the first invention to the seventh invention, at least any of the first principal surface of the first substrate portion and the second principal surface of the second substrate portion is formed in a curved shape.

In the power generation element according to the ninth invention, in any of the first invention to the eighth invention, the first electrode portion provided on the first substrate portion has a high wettability to the intermediate portion compared with the first principal surface of the first substrate portion.

In the power generation element according to the tenth invention, in any of the first invention to the ninth invention, the first joint surface includes a first substrate joint surface in contact with the second joint surface, and a first electrode joint surface in contact with the second electrode portion provided on the second substrate portion. The second joint surface includes a second substrate joint surface in contact with the first substrate joint surface, and a second electrode joint surface in contact with the first electrode portion provided on the first substrate portion.

In the power generation element according to the eleventh invention, in any of the first invention to the tenth invention, the first separated surface includes a contact surface in contact with the first electrode portion, a first surface having a portion provided outside the contact surface, and a second surface provided outside the first surface. The first surface has a high wettability to the intermediate portion compared with the second surface.

The power generation element according to the twelfth invention, in any of the first invention to the eleventh invention, further includes a sealing portion provided between the first electrode portion provided on the first substrate portion and the first joint surface and between the second electrode portion provided on the second substrate portion and the second joint surface. The sealing portion surrounds the intermediate portion.

The power generation element according to the thirteenth invention, in any of the first invention to the twelfth invention, further includes a protective film at least surrounding a side surface of the first substrate portion and a side surface of the second substrate portion.

A power generation device according to the fourteenth invention is a power generation device that includes a power generation element that converts a thermal energy into an electric energy. The power generation element includes a substrate, an electrode portion, and an intermediate portion. The substrate includes mutually opposed first principal surface and second principal surface. The electrode portion is provided on the first principal surface and the second principal surface. The electrode portion includes a first electrode portion and a second electrode portion. The second electrode portion has a work function different from a work function of the first electrode portion. The intermediate portion includes nanoparticles having a work function between the work function of the first electrode portion and the work function of the second electrode portion. The substrate includes a first substrate portion and a second substrate portion that are mutually overlapped viewed in a first direction intersecting with the first principal surface and the second principal surface. The intermediate portion is sandwiched between the first electrode portion provided on the first principal surface of the first substrate portion and the second electrode portion provided on the second principal surface of the second substrate portion. The first principal surface of the first substrate portion includes a first separated surface and a first joint surface. The first separated surface is in contact with the first electrode portion provided on the first substrate portion and separated from the second substrate portion. The first joint surface is provided to be continuous with the first separated surface, separated from the first electrode portion provided on the first substrate portion, and in contact with the second substrate portion. The second principal surface of the second substrate portion includes a second separated surface and a second joint surface. The second separated surface is in contact with the second electrode portion provided on the second substrate portion and separated from the first substrate portion. The second joint surface is provided to be continuous with the second separated surface, separated from the second electrode portion provided on the second substrate portion, and in contact with the first substrate portion.

An electronic apparatus according to the fifteenth invention is an electronic apparatus that includes a power generation element that converts a thermal energy into an electric energy and an electronic apparatus configured to be driven using the power generation element as a power supply. The power generation element includes a substrate, an electrode portion, and an intermediate portion. The substrate includes mutually opposed first principal surface and second principal surface. The electrode portion is provided on the first principal surface and the second principal surface. The electrode portion includes a first electrode portion and a second electrode portion. The second electrode portion has a work function different from a work function of the first electrode portion. The intermediate portion includes nanoparticles having a work function between the work function of the first electrode portion and the work function of the second electrode portion. The substrate includes a first substrate portion and a second substrate portion that are mutually overlapped viewed in a first direction intersecting with the first principal surface and the second principal surface. The intermediate portion is sandwiched between the first electrode portion provided on the first principal surface of the first substrate portion and the second electrode portion provided on the second principal surface of the second substrate portion. The first principal surface of the first substrate portion includes a first separated surface and a first joint surface. The first separated surface is in contact with the first electrode portion provided on the first substrate portion and separated from the second substrate portion. The first joint surface is provided to be continuous with the first separated surface, separated from the first electrode portion provided on the first substrate portion, and in contact with the second substrate portion. The second principal surface of the second substrate portion includes a second separated surface and a second joint surface. The second separated surface is in contact with the second electrode portion provided on the second substrate portion and separated from the first substrate portion. The second joint surface is provided to be continuous with the second separated surface, separated from the second electrode portion provided on the second substrate portion, and in contact with the first substrate portion.

A method for manufacturing a power generation element according to the sixteenth invention is a method for manufacturing a power generation element that converts a thermal energy into an electric energy. The method includes: a first electrode portion formation step of forming a first electrode portion on at least any of a first principal surface of a substrate and a second principal surface opposing the first principal surface; a second electrode portion formation step of forming a second electrode portion on at least any of the first principal surface and the second principal surface, the second electrode portion having a work function different from a work function of the first electrode portion; an intermediate portion formation step of forming an intermediate portion including nanoparticles on the first electrode portion formed on the first principal surface of a first substrate portion included in the substrate, the nanoparticles having a work function between the work function of the first electrode portion and the work function of the second electrode portion; and a joining step of joining the first electrode portion formed on the first principal surface of the first substrate portion and the second electrode portion formed on the second principal surface of a second substrate portion included in the substrate such that the first electrode portion and the second electrode portion are overlapped viewed in a first direction intersecting with the first principal surface and the second principal surface. After the joining step, the first principal surface of the first substrate portion includes a first separated surface and a first joint surface. The first separated surface is in contact with the first electrode portion formed on the first substrate portion and separated from the second substrate portion. The first joint surface is formed to be continuous with the first separated surface, separated from the first electrode portion formed on the first substrate portion, and in contact with the second substrate portion. The second principal surface of the second substrate portion includes a second separated surface and a second joint surface. The second separated surface is in contact with the second electrode portion formed on the second substrate portion and separated from the first substrate portion. The second joint surface is formed to be continuous with the second separated surface, separated from the second electrode portion formed on the second substrate portion, and in contact with the first substrate portion.

The method for manufacturing a power generation element according to the seventeenth invention, in the sixteenth invention, further includes a surface treatment step of performing a surface treatment to the first principal surface positioned in a peripheral area of the first electrode portion formed on the first substrate portion before the intermediate portion formation step and the joining step.

In the method for manufacturing a power generation element according to the eighteenth invention, in the sixteenth invention or the seventeenth invention, the joining step is performed in a state where a pressure between the first substrate portion and the second substrate portion is reduced.

### EFFECTS OF THE INVENTION

According to the first invention to the fifteenth invention, the first principal surface of the first substrate portion includes a first separated surface that is in contact with the first electrode portion provided on the first substrate portion and separated from the second substrate portion, and a first joint surface that is provided to be continuous with the first separated surface, separated from the first electrode portion provided on the first substrate portion, and in contact with the second substrate portion. The second principal surface of the second substrate portion includes a second separated surface that is in contact with the second electrode portion provided on the second substrate portion and separated from the first substrate portion, and a second joint surface that is provided to be continuous with the second separated surface, separated from the second electrode portion provided on the second substrate portion, and in contact with the first substrate portion. That is, the intermediate portion that can be formed by joining the principal surfaces on which the respective electrode portions are provided is interposed, thereby forming the interelectrode gap. Therefore, the need for additionally providing a support member or the like is eliminated, and the variation of the interelectrode gap can be suppressed. Accordingly, the stabilized generation amount of the electric energy can be achieved.

According to the first invention to the fifteenth invention, the electrode portions are provided on the first principal surface and the second principal surface. That is, the substrate is sandwiched between the electrode portions. Therefore, when the power generation element of the stacked structure is provided, the thickness in the first direction can be suppressed. Accordingly, downsizing of the power generation element can be ensured.

Especially, according to the second invention, the first electrode portions are provided on the first principal surface of the first substrate portion and the first principal surface of the second substrate portion. The second electrode portions are provided on the second principal surface of the first substrate portion and the second principal surface of the second substrate portion. That is, the substrate portions are each provided with the first electrode portion and the second electrode portion sandwiching the substrate portion. Therefore, when the power generation element of the stacked structure is formed, it can be easily achieved. Accordingly, facilitation of the manufacturing process can be ensured.

Especially, according to the third invention, the first electrode portions are provided on the first principal surface and the second principal surface of the first substrate portion. The second electrode portions are provided on the first principal surface and the second principal surface of the second substrate portion. That is, any of the first electrode portion or the second electrode portion is provided on each of the substrate portions. Therefore, when one electrode portion is formed, a possibility of forming to be in contact with the other electrode portion can be suppressed. Accordingly, yield improvement in manufacturing the power generation element can be ensured.

Especially, according to the fourth invention, the intermediate portion is surrounded by the first joint surface and the second joint surface viewed in the first direction. Therefore, the closed space surrounding the intermediate portion can be formed by the respective joint surfaces of the principal surfaces on which the respective electrode portions are provided. Accordingly, leaking out or the like of the intermediate portion can be easily suppressed without forming another configuration on the substrate.

Especially, according to the fifth invention, the first connection wiring and the second connection wiring are provided on the side surfaces of the substrate. Therefore, the respective connection wirings to be electrically connected to the electrode portions can be easily provided. Accordingly, facilitation of the manufacturing process can be ensured. Even in a case where the connection wirings are each deteriorated in accordance with the use of the power generation element, the repair can be easily made.

Especially, according to the sixth invention, the first connection wiring extends in the first direction and is in contact with a plurality of the first electrode portions. The second connection wiring extends in the first direction and is in contact with a plurality of the second electrode portions. Therefore, also in the case where the plurality of respective substrate portions are stacked, the connection wirings to be electrically connected to the respective electrode portions can be easily provided. Accordingly, facilitation of the manufacturing process can be ensured. Stress concentration parts of the respective connection wirings can be decreased, thus allowing suppressing wire disconnection and the like of the respective connection wirings.

Especially, according to the seventh invention, the side surface of the first electrode portion provided on the first substrate portion and the side surface of the second electrode portion provided on the second substrate portion are in contact with the intermediate portion. Therefore, electrons can be moved via the side surfaces of the respective electrode portions in addition to the opposing surfaces of the respective electrode portions. Accordingly, the generation amount of the electric energy can be increased.

Especially, according to the eighth invention, at least any of the first principal surface of the first substrate portion and the second principal surface of the second substrate portion is formed in a curved shape. Therefore, a portion such as a protrusion to which a stress is locally concentrated is not formed. Accordingly, a damage due to an impact from outside can be suppressed. When a film-shaped flexible material is used as the substrate and formed in a curved-shape, joining the respective substrate portions can be easily achieved.

Especially, according to the ninth invention, the first electrode portion provided on the first substrate portion has the high wettability to the intermediate portion compared with the first principal surface of the first substrate portion. Therefore, the nanoparticles dispersed in the solvent included in the intermediate portion can be easily kept between the respective electrode portions. Accordingly, the reduction over time in generation amount of the electric energy can be suppressed.

Especially, according to the tenth invention, the first joint surface includes the first substrate joint surface in contact with the second joint surface, and the first electrode joint surface in contact with the second electrode portion provided on the second substrate portion. The second joint surface includes the second substrate joint surface in contact with the first substrate joint surface, and the second electrode joint surface in contact with the first electrode portion provided on the first substrate portion. Therefore, the areas in which the respective electrode portions are provided on the substrates can be increased, thus allowing increasing the opposing areas of the respective electrode portions. Accordingly, the generation amount of the electric energy can be increased.

Especially, according to the eleventh invention, the first surface has the high wettability to the intermediate portion compared with the second surface. Therefore, the oozing of the intermediate portion from the respective joint surfaces can be suppressed. Accordingly, the reduction over time in the amount of the intermediate portion can be suppressed.

Especially, according to the twelfth invention, the sealing portion is provided between the first electrode portion provided on the first substrate portion and the first joint surface and between the second electrode portion provided on the second substrate portion and the second joint surface, and surrounds the intermediate portion. Therefore, the oozing of the intermediate portion from the respective joint surfaces can be suppressed. Accordingly, the reduction over time in the amount of the intermediate portion can be suppressed.

Especially, according to the thirteenth invention, the protective film at least surrounds the side surface of the first substrate portion and the side surface of the second substrate portion. Therefore, the deterioration of the substrate due to an external factor can be suppressed. Accordingly, the time deterioration of the power generation element can be suppressed.

Especially, according to the fourteenth invention, the power generation device including a power generation element that ensures stabilization of the generation amount of the electric energy can be achieved.

Especially, according to the fifteenth invention, the electronic apparatus including a power generation element that ensures stabilization of the generation amount of the electric energy can be achieved.

According to the sixteenth invention to the eighteenth invention, in the joining step, the first substrate portion and the second substrate portion are joined so as to be overlapped viewed in the first direction. At this time, the first principal surface of the first substrate portion includes a first separated surface that is in contact with the first electrode portion formed on the first substrate portion and separated from the second substrate portion, and a first joint surface that is formed to be continuous with the first separated surface, separated from the first electrode portion formed on the first substrate portion, and in contact with the second substrate portion. The second principal surface of the second substrate portion includes a second separated surface that is in contact with the second electrode portion formed on the second substrate portion and separated from the first substrate portion, and a second joint surface that is formed to be continuous with the second separated surface, separated from the second electrode portion formed on the second substrate portion, and in contact with the first substrate portion. That is, the intermediate portion that can be formed by joining the respective principal surfaces on which the electrode portions are provided is interposed, thereby forming the interelectrode gap. Therefore, the need for additionally providing a support member or the like is eliminated, and the variation of the interelectrode gap can be suppressed. Accordingly, the stabilized generation amount of the electric energy can be achieved.

According to the sixteenth invention to the eighteenth invention, the first electrode portion is formed on the first principal surface of the substrate, and the second electrode portion is formed on the second principal surface. That is, the substrate is sandwiched between the respective electrode portions. Therefore, when the power generation element of the stacked structure is provided, the thickness in the first direction can be suppressed. Accordingly, downsizing of the power generation element can be ensured.

Especially, according to the seventeenth invention, in the surface treatment step, the surface treatment is performed to the first principal surface positioned in a peripheral area of the first electrode portion formed on the first substrate portion. Therefore, when the intermediate portion formation step is performed, the intermediate portion can be easily kept on the first electrode portion. Accordingly, the intermediate portion can be easily formed.

Especially, according to the eighteenth invention, the joining step is performed in a state where a pressure between the first substrate portion and the second substrate portion is reduced. Therefore, air and the like can be removed from inside the gap portion in which the interelectrode gap is formed, thereby allowing easily filling inside the gap portion with the intermediate portion. Accordingly, facilitating the manufacturing process can be ensured.

### BRIEF DESCRIPTION OF THE DRAWINGS

Fig. 1A is a schematic cross-sectional view illustrating exemplary power generation device and power generation element in a first embodiment, Fig. 1B is a schematic cross-sectional view illustrating an exemplary substrate, and Fig. 1C is a schematic cross-sectional view taken along 1C-1C of Fig. 1B.
Fig. 2A is a schematic plan view along 2A-2A of Fig. 1A, and Fig. 2B is a schematic plan view along 2B-2B of Fig. 1A.
Fig. 3A is a schematic cross-sectional view illustrating an exemplary intermediate portion, and Fig. 3B is a schematic cross-sectional view illustrating another exemplary intermediate portion.
Fig. 4A and Fig. 4B are flowcharts illustrating an exemplary method for manufacturing the power generation element in the first embodiment.
Fig. 5A to Fig. 5D are schematic cross-sectional views illustrating the exemplary method for manufacturing the power generation element in the first embodiment.
Fig. 6 is a schematic cross-sectional view illustrating an exemplary joining step.
Fig. 7A and Fig. 7B are schematic diagrams illustrating an exemplary intermediate portion formation step.
Fig. 8A and Fig. 8B are schematic cross-sectional views illustrating another exemplary method for manufacturing the power generation element in the first embodiment.
Fig. 9A and Fig. 9B are schematic diagrams illustrating a modification of the substrate.
Fig. 10A is a flowchart illustrating a modification of the method for manufacturing the power generation element in the first embodiment, and Fig. 10B to Fig. 10D are schematic diagrams illustrating the modification of the method for manufacturing the power generation element in the first embodiment.
Fig. 11A and Fig. 11B are schematic diagrams illustrating a first modification of the power generation element in the first embodiment.
Fig. 12A and Fig. 12B are schematic diagrams illustrating a second modification of the power generation element in the first embodiment.
Fig. 13 is a schematic cross-sectional view illustrating a third modification of the power generation element in the first embodiment.
Fig. 14 is a schematic cross-sectional view illustrating other examples of the power generation device and the power generation element in the first embodiment.
Fig. 15 is a schematic cross-sectional view illustrating exemplary power generation device and power generation element in a second embodiment.
Fig. 16 is a schematic cross-sectional view illustrating other examples of the power generation device and the power generation element in the second embodiment.
Fig. 17A to Fig. 17D are schematic block diagrams illustrating examples of an electronic apparatus including the power generation element, and Fig. 17E to Fig. 17H are schematic block diagrams illustrating examples of an electronic apparatus including a power generation device with a power generation element.

### DESCRIPTION OF PREFERRED EMBODIMENTS

The following describes one example of each of a power generation element, a power generation device, an electronic apparatus, and a method for manufacturing the power generation element in the embodiments of the present invention by referring to the drawings. In each drawing, a height direction in which respective substrate portions are joined is defined as a first direction Z, one planar direction intersecting with, for example, perpendicular to the first direction Z is defined as a second direction X, and another planar direction intersecting with, for example, perpendicular to each of the first direction Z and the second direction X is defined as a third direction Y. The configurations in the respective drawings are schematically illustrated for explanation, and for example, sizes of the respective configurations, ratios between sizes in each configuration, and the like may be different from the drawings.

### (First Embodiment: Power Generation Device 100, Power Generation Element 1)

### <Power Generation Device 100>

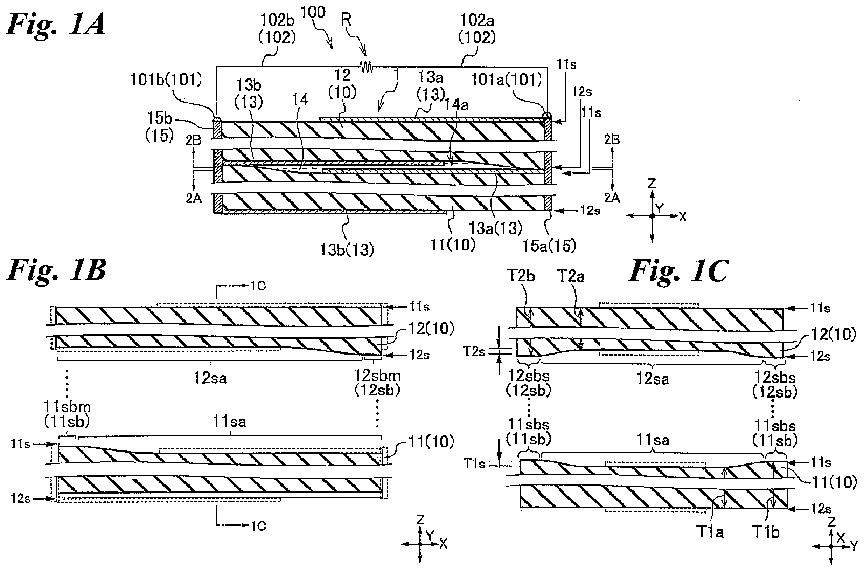

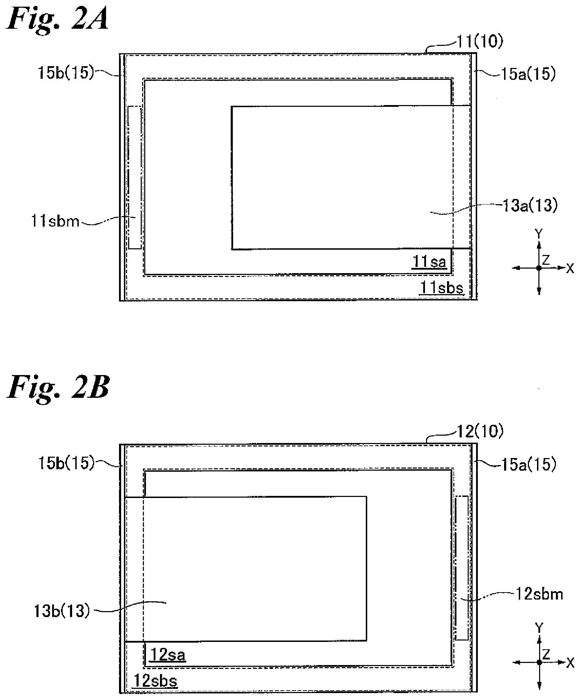

Fig. 1 and Fig. 2 are schematic diagrams illustrating exemplary power generation device 100 and power generation element 1 in the first embodiment. Fig. 1A is a schematic cross-sectional view illustrating the exemplary power generation device 100 and power generation element 1 in the first embodiment, Fig. 1B is a schematic cross-sectional view illustrating an exemplary substrate 10, and Fig. 1C is a schematic plan view along 1C-1C of Fig. 1B. Fig. 2A is a schematic plan view along 2A-2A of Fig. 1A, and Fig. 2B is a schematic plan view along 2B-2B of Fig. 1A.

As illustrated in Fig. 1, the power generation device 100 includes the power generation element 1, a terminal 101, and a wiring 102. The power generation element 1 converts a thermal energy into an electric energy. The power generation device 100 including the power generation element 1 is, for example, mounted or installed to a heat source (not illustrated), and outputs an electric energy generated by the power generation element 1 using a thermal energy of the heat source to a load R via the terminal 101 and the wiring 102.

The wiring 102 includes a first wiring 102a electrically connected to one end of the load R and a second wiring 102b electrically connected to the other end of the load R. The load R indicates, for example, electrical equipment, and for example, can be driven using the power generation element 1 as a main power supply or an auxiliary power supply.

As the heat source of the power generation element 1, for example, an electronic device or an electronic part, such as a Central Processing Unit (CPU), a light-emitting element, such as a Light Emitting Diode (LED), an engine of an automobile or the like, a production facility of a plant, a human body, a solar light, and an environmental temperature are usable. For example, the electronic device, the electronic part, the light-emitting element, the engine, and the production facility are artificial heat sources. The human body, the solar light, the environmental temperature, and the like are natural heat sources. The power generation device 100 including the power generation element 1 can be provided in an electronic apparatus such as an Internet of Things (IoT) device, a wearable device, and a free-standing sensor terminal, and can be used as an alternative or an auxiliary of a battery. A power generation principle of the power generation element 1 can be used for a temperature sensor and the like. Furthermore, the power generation device 100 is applicable to a larger-sized power generation device such as solar power generation.

### <Power Generation Element 1>

The power generation element 1 converts, for example, a thermal energy emitted from the above-described artificial heat source or a thermal energy of the above-described natural heat source into an electric energy, thus generating a current. The power generation element 1 is provided in the power generation device 100, and additionally, the power generation element 1 itself can be provided inside the above-described mobile device and the electronic apparatus such as a free-standing sensor terminal described above. In this case, the power generation element 1 itself can be an alternative component or an auxiliary component of a battery for the electronic apparatus.

The power generation element 1 includes the substrate 10, an electrode portion 13, and an intermediate portion 14. The power generation element 1 may include, for example, a connection wiring 15.

The substrate 10 includes mutually opposing first principal surface 11s and second principal surface 12s. The principal surfaces 11s, 12s each intersect with the first direction Z. The substrate 10 includes a first substrate portion 11 and a second substrate portion 12 mutually overlapping viewed in the first direction Z. The substrate portions 11, 12 each include principal surfaces 11s, 12s. At least a part of the first principal surface 11s of the first substrate portion 11 is in contact with, and for example, joined to at least a part of the second principal surface 12s of the second substrate portion 12.

The electrode portions 13 are provided on the first principal surface 11s and the second principal surface 12s. That is, the substrate 10 is sandwiched between a pair of the electrode portions 13. The electrode portion 13 includes a first electrode portion 13a and a second electrode portion 13b.

In this embodiment, the first electrode portions 13a are provided on the first principal surfaces 11s (on the first principal surface 11s of the first substrate portion 11 and on the first principal surface 11s of the second substrate portion 12) of the substrates 10. The second electrode portions 13b are provided on the second principal surfaces 12s (on the second principal surface 12s of the first substrate portion 11 and on the second principal surface 12s of the second substrate portion 12) of the substrates 10. That is, each of the substrate portions 11, 12 is provided with the electrode portions 13a, 13b, and each of the substrate portions 11, 12 is sandwiched between the electrode portions 13a and 13b.

The first electrode portion 13a provided on the first substrate portion 11 is separated from the second electrode portion 13b provided on the second substrate portion 12, in contact with, and for example, joined to a part of the second principal surface 12s of the second substrate portion 12. The second electrode portion 13b provided on the second substrate portion 12 is separated from the first electrode portion 13a provided on the first substrate portion 11, in contact with, and for example, joined to a part of the first principal surface 11s of the first substrate portion 11.

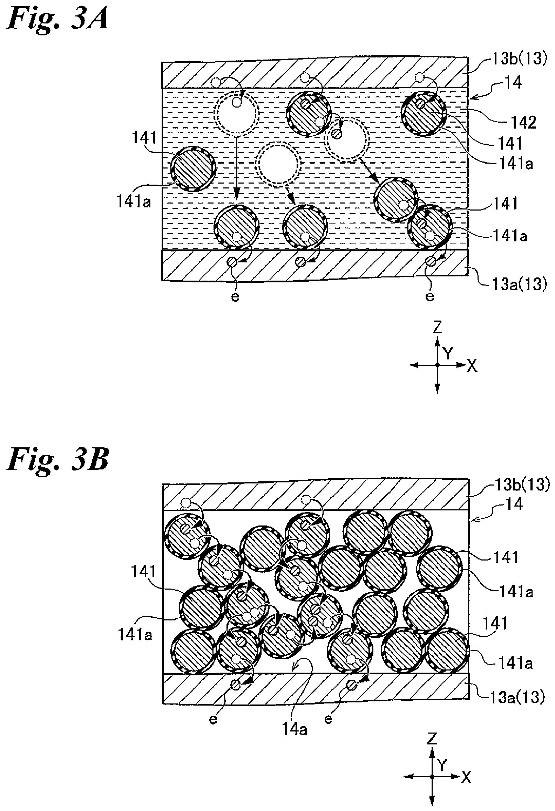

The intermediate portion 14 is provided between the first substrate portion 11 and the second substrate portion 12. The intermediate portion 14 is sandwiched between the first electrode portion 13a provided on the first substrate portion 11 and the second electrode portion 13b provided on the second substrate portion 12. The intermediate portion 14 includes, for example, nanoparticles 141 illustrated in Fig. 3, and may include, for example, a solvent 142 in which the nanoparticles 141 are dispersed.

The connection wiring 15 is provided on the side surface of the substrate 10. The connection wiring 15 includes, for example, a first connection wiring 15a and a second connection wiring 15b. The connection wirings 15a, 15b each extend in, for example, the first direction Z, and are provided to be mutually opposed.

The first connection wiring 15a is in contact with the first electrode portions 13a provided on the respective substrate portions 11, 12, and for example, electrically connected to the first wiring 102a via a first terminal 101a. The second connection wiring 15b is in contact with the second electrode portions 13b provided on the respective substrate portions 11, 12, and for example, electrically connected to the second wiring 102b via a second terminal 101b.

The power generation element 1 is provided with a gap portion 14a. The gap portion 14a means a portion mainly surrounded by the first substrate portion 11 and the second substrate portion 12, and includes a space separated from outside. In the gap portion 14a, the first electrode portion 13a, the second electrode portion 13b, and the intermediate portion 14 are provided. The electrode portions 13a, 13b provided in the gap portion 14a are provided on the mutually different substrate portions 11, 12. An inner side of the power generation element 1 means a portion including the gap portion 14a, and an outer side of the power generation element 1 means a portion separated from the gap portion 14a.

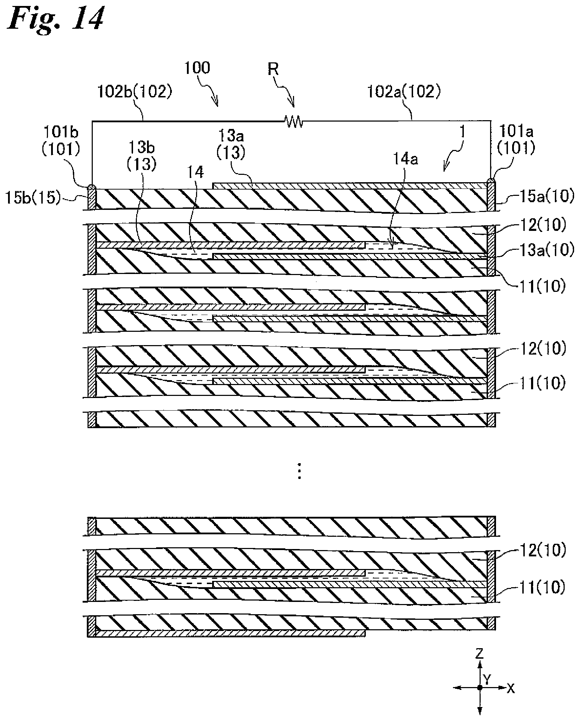

For example, as illustrated in Fig. 14, the power generation element 1 may have a structure in which the configurations described above are stacked. That is, a plurality of the first substrate portions 11 and a plurality of the second substrate portions 12 are stacked in the first direction Z, and a plurality of the intermediate portions 14 are provided between the respective substrate portions 11, 12. In this case, the first connection wiring 15a extends in the first direction Z along the side surfaces of the stacked substrate portions 11, 12, and is in contact with the plurality of first electrode portions 13a. The second connection wiring 15b is opposed to the first connection wiring 15a, extends in the first direction Z along the side surfaces of the stacked substrate portions 11, 12, and is in contact with the plurality of second electrode portions 13b. Therefore, the respective electrode portions 13a, 13b are connected via the connection wirings 15a, 15b, respectively. The power generation device 100 may include the power generation element 1 having the stacked structure.

The following describes the configurations of the power generation element 1 and the power generation device 100 in the first embodiment in more detail.

### «First substrate portion 11, Second substrate portion 12»

For example, as illustrated in Fig. 1B and Fig. 1C, the first principal surface 11s of the first substrate portion 11 includes a first separated surface 11sa and a first joint surface 11sb. The first separated surface 11sa is in contact with the first electrode portion 13a provided on the first substrate portion 11, and separated from the second substrate portion 12. The first joint surface 11sb is separated from the first electrode portion 13a provided on the first substrate portion 11.

The second principal surface 12s of the second substrate portion 12 includes a second separated surface 12sa and a second joint surface 12sb. The second separated surface 12sa is in contact with the second electrode portion 13b provided on the second substrate portion 12, and separated from the first substrate portion 11. The second joint surface 12sb is separated from the second electrode portion 13b provided on the second substrate portion 12.

For example, viewed in the first direction Z illustrated in Fig. 2A, the first substrate portion 11 is formed in a quadrilateral shape, and additionally, for example, may be formed in a polygonal shape with cut-outs, a circular shape, and the like. A part of the first separated surface 11sa overlaps the first electrode portion 13a provided on the first substrate portion 11. At least a part of the first joint surface 11sb is provided outside the first separated surface 11sa. The first electrode portion 13a provided on the first substrate portion 11 and the first separated surface 11sa are surrounded by the first joint surface 11sb and the first connection wiring 15a.

For example, viewed in the first direction Z illustrated in Fig. 2B, the second substrate portion 12 is formed in a quadrilateral shape, and additionally, for example, may be formed in a polygonal shape with cut-outs, a circular shape, and the like. A part of the second separated surface 12sa overlaps the second electrode portion 13b provided on the second substrate portion 12. At least a part of the second joint surface 12sb is provided outside the second separated surface 12sa. The second electrode portion 13b provided on the second substrate portion 12 and the second separated surface 12sa are surrounded by the second joint surface 12sb and the second connection wiring 15b.

The substrate portions 11, 12 are joined at joint surfaces 11sb, 12sb, and for example, joined in a region indicated by dashed lines in Fig. 2A and Fig. 2B. That is, viewed in the first direction Z, the intermediate portion 14 is surrounded by the first joint surface 11sb and the second joint surface 12sb. Therefore, a closed space (gap portion 14a) surrounding the intermediate portion 14 can be easily formed by the joint surfaces 11sb, 12sb of the principal surfaces 11s, 12s on which the electrode portions 13a, 13b are provided, respectively.

Since the above-described substrate portions 11, 12 include the separated surfaces 11sa, 12sa and the joint surfaces 11sb, 12sb, respectively, the interelectrode gap is formed between the electrode portions 13a and 13b. That is, the interelectrode gap can be formed without providing a supporting portion or the like for supporting between the respective substrate portions 11, 12. Therefore, the variation of the interelectrode gap can be suppressed.

The first joint surface 11sb is provided to be continuous with the first separated surface 11sa. The second joint surface 12sb is provided to be continuous with the second separated surface 12sa. Therefore, for example, when an external force is applied to a part of each of the joint surfaces 11sb, 12sb, the force can be easily dispersed to the entire substrate portions 11, 12. Accordingly, an early deterioration of the power generation element 1 can be suppressed.

Especially, at least any of the first principal surface 11s and the second principal surface 12s can be formed in a curved shape, for example, as illustrated in Fig. 1B and Fig. 1C. Therefore, for example, compared with a case where a supporting portion or the like is provided on the principal surface, a portion such as a protrusion to which a stress is locally concentrated is not formed. When a film-shaped flexible material is used as the substrate 10 and formed in a curved-shape, joining the respective substrate portions 11, 12 can be easily achieved.

The joint surfaces 11sb, 12sb are each adjacent to, for example, the side surface of the substrate 10. The first joint surface 11sb includes, for example, a first substrate joint surface 11sbs and a first electrode joint surface 11sbm. The second joint surface 12sb includes, for example, a second substrate joint surface 12sbs and a second electrode joint surface 12sbm.

The first substrate joint surface 11sbs is in contact with the second substrate joint surface 12sbs. The first electrode joint surface 11sbm is in contact with the second electrode portion 13b provided on the second substrate portion 12. The second electrode joint surface 12sbm is in contact with the first electrode portion 13a provided on the first substrate portion 11.

In this embodiment, the substrate portions 11, 12 are mutually joined at each of the first substrate joint surface 11sbs and the second substrate joint surface 12sbs, the first electrode joint surface 11sbm and the second electrode portion 13b provided on the second substrate portion 12, and the first electrode portion 13a provided on the first substrate portion 11 and the second electrode joint surface 12sbm, and for example, joined in the region indicated by dashed lines in Fig. 2. That is, viewed in the first direction Z, the intermediate portion 14 is surrounded by the first joint surface 11sb and the second joint surface 12sb. Therefore, the closed space (gap portion 14a) surrounding the intermediate portion 14 can be easily formed by the joint surfaces 11sb, 12sb.

In the case of joining in the above-described region, the areas on which the respective electrode portions 13a, 13b are provided can be increased compared with the case where the respective electrode portions 13a, 13b are provided inside the gap portion 14a while being separated from the principal surfaces 11s, 12s. Therefore, the opposing areas of the respective electrode portions 13a, 13b can be increased.

By joining of the first electrode portion 13a provided on the first substrate portion 11 and the second electrode joint surface 12sbm and joining of the second electrode portion 13b provided on the second substrate portion 12 and the first electrode joint surface 11sbm, the electrical connection with the respective electrode portions 13a, 13b can be easily achieved from the side surfaces of the substrate 10.

Along the first direction Z, the substrate portions 11, 12 each have a thickness of, for example, 10 µm or more and 1 mm or less. For example, as illustrated in Fig. 1C, along the first direction Z, a difference T1s between the height of the first separated surface 11sa and the height of the first joint surface 11sb is significantly small compared with the thickness of the first substrate portion 11. Therefore, a thickness T1a of the first substrate portion 11 starting from the first separated surface 11sa is equal to a thickness T1b of the first substrate portion 11 starting from the first joint surface 11sb. Along the first direction Z, a difference T2s between the height of the second separated surface 12sa and the height of the second joint surface 12sb is significantly small compared with the thickness of the second substrate portion 12. Therefore, a thickness T2a of the second substrate portion 12 starting from the second separated surface 12sa is equal to a thickness T2b of the second substrate portion 12 starting from the second joint surface 12sb. Accordingly, a process of removing a part of at least any of the substrate portions 11 and 12, or the like is not performed, thus allowing suppressing local reduction of proof strengths of the respective substrate portions 11, 12. It is not necessary to perform the process of partially removing at least any of the substrate portions 11, 12, a process of stacking an additional configuration on the substrate portions 11, 12, or the like, thus allowing ensuring reduction of the manufacturing process. Also in the case where a plurality of the respective substrate portions 11, 12 are stacked, the gap portion 14a can be provided between the respective substrate portions 11, 12 while being not affected by the respective differences T1s, T2s.

For example, along the second direction X or the third direction Y, the substrate portions 11, 12 each have a width of about 1 mm to 500 mm, and the widths can be appropriately set depending on the usage.

As the material of the substrate 10, a plate-shaped insulating material can be selected. As examples of the insulating material, silicon, quartz, a glass such as Pyrex (registered trademark), an insulating resin, and the like can be included.

The substrate 10 may have a thin plate shape, and additionally, for example, may have a flexible film shape. For example, when the substrate 10 is formed in a flexible film shape, for example, a thin plate glass and a film containing a polymer of polyethylene terephthalate (PET), polycarbonate (PC), polyimide, and the like as a material are usable. By using a film-shaped material as the substrate 10, the curved shape is easily formed, and the joining of the respective substrate portions 11, 12 can be easily achieved.

Between the first substrate portion 11 and the second substrate portion 12 (inner side of the power generation element 1), the respective electrode portion 13a, 13b are partially provided, and the intermediate portion 14 is internally provided. Therefore, by providing the first substrate portion 11 and the second substrate portion 12, the deterioration and the deformation of each of the first electrode portion 13a, the second electrode portion 13b, and the intermediate portion 14 due to the external force and the environmental change also can be suppressed. Accordingly, the durability of the power generation element 1 can be enhanced.

### «First Electrode Portion 13a, Second Electrode Portion 13b»

The first electrode portion 13a is provided on the first principal surface 11s, and has a portion, for example, exposed from the side surface of the substrate 10. The second electrode portion 13b is provided on the second principal surface 12s, and has a portion, for example, exposed from the side surface of the substrate 10. The exposed portions of the respective electrode portions 13a, 13b are exposed from any of a pair of opposing side surfaces of the substrate 10, and mutually separated.

The first electrode portion 13a provided on the first substrate portion 11 extends from between the first separated surface 11sa and the second separated surface 12sa to between the first separated surface 11sa and the second electrode joint surface 12sbm. The second electrode portion 13b provided on the second substrate portion 12 extends from between the second separated surface 12sa and the first separated surface 11sa to between the second separated surface 12sa and the first electrode joint surface 11sbm.

For example, along the first direction Z illustrated in Fig. 1A, the height of the surface of the first electrode portion 13a provided on the first substrate portion 11 is set to, for example, a height between the first separated surface 11sa and the first joint surface 11sb. Along the first direction Z, the height of the surface of the second electrode portion 13b is set to, for example, a height between the second separated surface 12sa and the second joint surface 12sb.

For example, viewed in the first direction Z illustrated in Fig. 2A, the first electrode portion 13a is formed in a quadrilateral shape, and additionally, for example, may be formed in a polygonal shape with cut-outs, a circular shape, and the like. For example, viewed in the first direction Z illustrated in Fig. 2B, the second electrode portion 13b is formed in a quadrilateral shape, and additionally, for example, may be formed in a polygonal shape with cut-outs, a circular shape, and the like.

The side surface of the first electrode portion 13a provided on the first substrate portion 11 and the side surface of the second electrode portion 13b provided on the second substrate portion 12 are in contact with the intermediate portion 14, for example, as illustrated in Fig. 1A. Therefore, move of the electrons e can be achieved via the side surfaces of the respective electrode portions 13a, 13b in addition to the opposing surfaces of the respective electrode portions 13a, 13b.

The first electrode portion 13a provided on the first substrate portion 11 has a high wettability to the solvent 142 included in the intermediate portion 14 compared with, for example, the first principal surface 11s of the first substrate portion 11. That is, the solvent 142 easily spreads over the first electrode portion 13a and is less likely to spread over the outer peripheral side (joint surface 11sb) of the first principal surface 11s. Therefore, the nanoparticles 141 dispersed in the solvent 142 can be easily kept between the respective electrode portions 13a, 13b forming the interelectrode gap. The second electrode portion 13b provided on the second substrate portion 12 may have a high wettability to the solvent 142 compared with, for example, the second principal surface 12s of the second substrate portion 12. As the respective electrode portions 13a, 13b, for example, materials having high wettability compared with the respective principal surfaces 11s, 12s are used, and additionally, surface treatments of the respective electrode portions 13a, 13b may be performed to increase the wettability. Surface treatments of the respective substrate portions 11, 12 may be performed to decrease the wettability of the respective principal surfaces 11s, 12s.

For example, as illustrated in Fig. 1A, the second electrode portion 13b provided on the first substrate portion 11 is provided outside the gap portion 14a. The second electrode portion 13b provided on the first substrate portion 11 is electrically connected to the second electrode portion 13b provided on the second substrate portion 12 via the second connection wiring 15b. Therefore, for example, the electrical connection with the second electrode portion 13b provided inside the gap portion 14a can be easily achieved using the second electrode portion 13b provided on the first substrate portion 11.

The first electrode portion 13a provided on the second substrate portion 12 is provided outside the gap portion 14a. The first electrode portion 13a provided on the second substrate portion 12 is electrically connected to the first electrode portion 13a provided on the first substrate portion 11 via the first connection wiring 15a. Therefore, for example, the electrical connection with the first electrode portion 13a provided inside the gap portion 14a can be easily achieved using the first electrode portion 13a provided on the second substrate portion 12.

The first electrode portion 13a contains, for example, platinum (work function: about 5.65 eV), and the second electrode portion 13b contains, for example, tungsten (work function: about 4.55 eV). The electrode portion having the large work function serves as an anode (collector electrode), and the electrode portion having the small work function serves as a cathode (emitter electrode). In the power generation element 1 according to the first embodiment, a description will be given with the first electrode portion 13a as the anode and the second electrode portion 13b as the cathode. The first electrode portion 13a may be the cathode and the second electrode portion 13b may be the anode.

In the power generation element 1, an electron emission phenomenon at an absolute temperature that occurs in the interelectrode gap between the first electrode portion 13a and the second electrode portion 13b having the work function difference can be used. Therefore, the power generation element 1 can convert a thermal energy to an electric energy even when the temperature difference between the first electrode portion 13a and the second electrode portion 13b is small. Furthermore, the power generation element 1 can convert a thermal energy to an electric energy even when there is no temperature difference between the first electrode portion 13a and the second electrode portion 13b or when a single heat source is used.

Along the first direction Z, the electrode portions 13a, 13b each have a thickness of, for example, 10 nm or more and 10 µm or less, and for example, 10 nm or more and 1 µm or less is preferred. For example, when the electrode portions 13a, 13b each have the thickness of 10 nm or more and 100 nm or less, each of the above-described principal surfaces 11s, 12s is easily kept in the curved shape.

For example, along the second direction X or the third direction Y, the electrode portions 13a, 13b each have a width of about 100 µm to 500 mm, and the widths can be appropriately set depending on the usage. Especially, when the widths of the respective electrode portions 13a, 13b are 1/10 or less compared with the widths of the respective substrate portions 11, 12, each of the above-described principal surfaces 11s, 12s is easily kept in the curved shape.

A distance (interelectrode gap) along the first direction Z between the first electrode portion 13a and the second electrode portion 13b is a finite value of, for example, 1 µm or less. 10 nm or more and 100 nm or less is more preferred. With the interelectrode gap set to 10 nm or more and 100 nm or less, the increase of the generation amount of the electric energy can be ensured. For example, when the interelectrode gap is less than 10 nm, there is a concern that a state where the nanoparticles 141 are evenly dispersed cannot be maintained.

By setting the thicknesses along the first direction Z of the respective electrode portions 13a, 13b and the interelectrode gap to the above-described ranges, for example, the thickness along the first direction Z of the power generation element 1 can be thinned. This is effective, for example, when a plurality of the power generation elements 1 are stacked along the first direction Z as illustrated in Fig. 14. Especially, for the substrate portions 11, 12, since the respective electrode portions 13a, 13b are provided on the opposing principal surfaces 11s, 12s, the interelectrode gap can be formed by stacking only any of the respective substrate portions 11, 12 in the stacking. Therefore, the number of the substrates 10 to be stacked as a main cause of the increased thickness due to the stacking can be reduced.

By setting the thicknesses along the first direction Z of the respective electrode portions 13a, 13b and the interelectrode gap to the above-described ranges, variation in plane of each of the electrode portions 13a, 13b can be suppressed, and the stability of the generation amount of the electric energy can be improved. Additionally, by setting the interelectrode gap to the above-described range, the electrons e can be efficiently emitted, and the electrons e can be efficiently moved from the second electrode portion 13b (cathode) to the first electrode portion 13a (anode).

The material of the first electrode portion 13a and the material of the second electrode portion 13b can be selected from, for example, metals below.
Platinum (Pt)
Tungsten (W)
Aluminum (Al)
Titanium (Ti)
Niobium (Nb)
Molybdenum (Mo)
Tantalum (Ta)
Rhenium (Re)

In the power generation element 1, it is only necessary that the work function difference is generated between the first electrode portion 13a and the second electrode portion 13b. Therefore, for the materials of the respective electrode portions 13a, 13b, the metal other than those described above can be selected. As the materials of the respective electrode portions 13a, 13b, an alloy, an intermetallic compound, and a metal compound can be selected in addition to the metal. The metal compound is one in which a metallic element and a non-metallic element are combined. The example of the metal compound can include lanthanum hexaboride (LaB₆) and the like.

As the materials of the respective electrode portions 13a, 13b, a non-metallic conductive material can be selected. The example of the non-metallic conductive material can include silicon (Si: for example, p-type Si or n-type Si), a carbon-based material such as graphene, and the like.

The structure of each of the electrode portions 13a, 13b may be a stacked structure containing the above-described materials in addition to a single layer structure containing the above-described material.

### «Intermediate Portion 14»

For example, as illustrated in Fig. 3, the intermediate portion 14 is a portion in which the electrons e emitted from the second electrode portion 13b (cathode) forming the interelectrode gap across the intermediate portion 14 are moved to the first electrode portion 13a (anode). Fig. 3A is a schematic cross-sectional view illustrating an exemplary intermediate portion 14. As illustrated in Fig. 3A, the intermediate portion 14 includes, for example, a plurality of nanoparticles 141 and the solvent 142. The plurality of nanoparticles 141 are dispersed in the solvent 142. The intermediate portion 14 is obtained by, for example, filling the gap portion 14a with the solvent 142 in which the nanoparticles 141 are dispersed.

The nanoparticles 141 contains, for example, a conductive object. The value of the work function of the nanoparticles 141 is, for example, between the value of the work function of the first electrode portion 13a and the value of the work function of the second electrode portion 13b. For example, the plurality of nanoparticles 141 have the work function in a range of 3.0 eV or more and 5.5 eV or less. Therefore, the electrons e emitted between the first electrode portion 13a and the second electrode portion 13b can be moved, for example, from the second electrode portion 13b (cathode) to the first electrode portion 13a (anode) via the nanoparticles 141. Accordingly, the generation amount of the electric energy can be increased compared with a case where the intermediate portion 14 does not include the nanoparticles 141.

As the example of the material of the nanoparticle 141, at least one of gold and silver can be selected. The intermediate portion 14 only needs to include at least a part of the nanoparticles 141 having the work function between the work function of the first electrode portion 13a and the work function of the second electrode portion 13b. Accordingly, as the material of the nanoparticle 141, a conductive material other than gold or silver can be also selected.

The particle diameter of the nanoparticle 141 is, for example, 2 nm or more and 10 nm or less. The nanoparticles 141 may have, for example, the particle diameters with an average particle diameter (for example, D50) of 3 nm or more and 8 nm or less. The average particle diameter can be measured using, for example, a particle size distribution meter. As the particle size distribution meter, for example, a particle size distribution meter using a laser diffraction scattering method (for example, Nanotrac Wave II-EX150 manufactured by MicrotracBEL) may be used.

The nanoparticle 141 includes, for example, an insulating film 141a on its surface. As the example of the material of the insulating film 141a, at least one of an insulating metal compound and an insulating organic compound can be selected. The exemplary insulating metal compound can include a silicon oxide, alumina, and the like. The exemplary insulating organic compound can include alkanethiol (for example, dodecanethiol) and the like. The thickness of the insulating film 141a is a finite value of, for example, 20 nm or less. By providing the insulating film 141a on the surface of the nanoparticle 141, the electrons e can move, for example, between the second electrode portion 13b (cathode) and the nanoparticles 141 and between the nanoparticles 141 and the first electrode portion 13a (anode) using a tunneling effect. Therefore, for example, the improvement of the power generation efficiency of the power generation element 1 can be expected. At this time, for example, as indicated by arrows in Fig. 3A, the move of the electrons e may be promoted using the move of the nanoparticles 141.

For the solvent 142, for example, a liquid with a boiling point of 60°C or more can be used. Therefore, even when the power generation element 1 is used under an environment of room temperature (for example, 15°C to 35°C) or more, vaporization of the solvent 142 can be suppressed. Accordingly, the deterioration of the power generation element 1 due to the vaporization of the solvent 142 can be suppressed. As the example of the liquid, at least one of an organic solvent and water can be selected. The exemplary organic solvent can include methanol, ethanol, toluene, xylene, tetradecane, alkanethiol, and the like. As the solvent 142, a liquid having a high electrical resistance value and an insulating property is appropriate.

Fig. 3B is a schematic cross-sectional view illustrating another exemplary intermediate portion 14. As illustrated in Fig. 3B, the intermediate portion 14 may include only the nanoparticles 141 without including the solvent 142.

With the intermediate portion 14 including only the nanoparticles 141, for example, even when the power generation element 1 is used under a high temperature environment, it is not necessary to consider the vaporization of the solvent 142. Accordingly, the deterioration of the power generation element 1 under the high temperature environment can be suppressed.

### «First Connection Wiring 15a, Second Connection Wiring 15b»

As the respective connection wirings 15a, 15b, conductive materials are used, and for example, gold is used.

For example, as illustrated in Fig. 2, the first connection wiring 15a is provided outside the second electrode joint surface 12sbm, and in contact with the first electrode portion 13a. The second connection wiring 15b is provided, for example, outside the first electrode joint surface 11sbm, and in contact with the second electrode portion 13b. Therefore, the connection wirings 15a, 15b to be electrically connected to the electrode portions 13a, 13b, respectively can be easily provided, and for example, facilitation of the manufacturing process of the power generation device 100 can be ensured.

Each of the connection wirings 15a, 15b is provided, for example, on the side surfaces of the substrate portions 11, 12. In this case, each of the electrode portions 13a, 13b forming the interelectrode gap is not exposed from the side surface of the substrate 10, thus allowing suppressing the deterioration of the respective electrode portions 13a, 13b. Since the connection wirings 15a, 15b are provided outside respective portions at which the electrode portions 13a, 13b and the electrode joint surfaces 11sbm, 12sbm are joined, leaking out and the like of the intermediate portion 14 from the joint portions can be avoided.

### «First Wiring 102a, Second Wiring 102b»

The first wiring 102a is electrically connected to the first electrode portion 13a provided on the first substrate portion 11 via the first terminal 101a and the first connection wiring 15a. The second wiring 102b is electrically connected to the second electrode portion 13b provided on the second substrate portion 12 via the second terminal 101b and the second connection wiring 15b.

For example, the first wiring 102a is electrically connected to the first electrode portion 13a provided on the first substrate portion 11 via the first electrode portion 13a provided on the second substrate portion 12. The second wiring 102b is electrically connected to the second electrode portion 13b provided on the second substrate portion 12 via the second electrode portion 13b provided on the first substrate portion 11. In this case, since the first electrode portion 13a provided on the second substrate portion 12 and the second electrode portion 13b provided on the first substrate portion 11 are each provided on the outer side of the substrate 10, the electrical connection between the wirings 102a, 102b and the electrode portions 13a, 13b, respectively can be easily achieved.

A conductive material is used for each of the wirings 102a, 102b, and for example, the material such as nickel, copper, silver, gold, tungsten, or titanium is used. The structure of each of the wirings 102a, 102b can be appropriately designed insofar as the current generated by the power generation element 1 can be supplied to the load R in the structure.

### <Operation of Power Generation Element 1>

When the thermal energy is provided to the power generation element 1, for example, the electrons e are emitted from the second electrode portion 13b (cathode) inside the gap portion 14a toward the intermediate portion 14. The emitted electrons e move from the intermediate portion 14 to the first electrode portion 13a (anode) inside the gap portion 14a (see Fig. 2). In this case, the current flows from the first electrode portion 13a toward the second electrode portion 13b. Thus, the thermal energy is converted into the electric energy.

The amount of the emitted electrons e depends on the thermal energy, and additionally, depends on the difference between the work function of the first electrode portion 13a (anode) and the work function of the second electrode portion 13b (cathode). The amount of the emitted electrons e tends to increase in the material having the smaller the work function of the second electrode portion 13b.

The amount of the moving electrons e can be increased by, for example, increasing the work function difference between the first electrode portion 13a and the second electrode portion 13b, or decreasing the interelectrode gap. For example, the amount of the electric energy generated by the power generation element 1 can be increased by considering at least any one of increasing the work function difference and decreasing the interelectrode gap.

### (First Embodiment: Method for Manufacturing Power Generation Element 1)

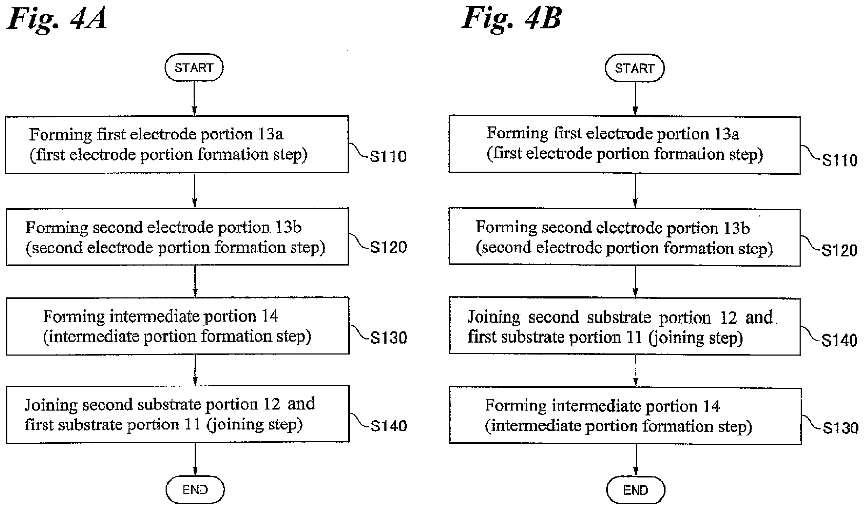

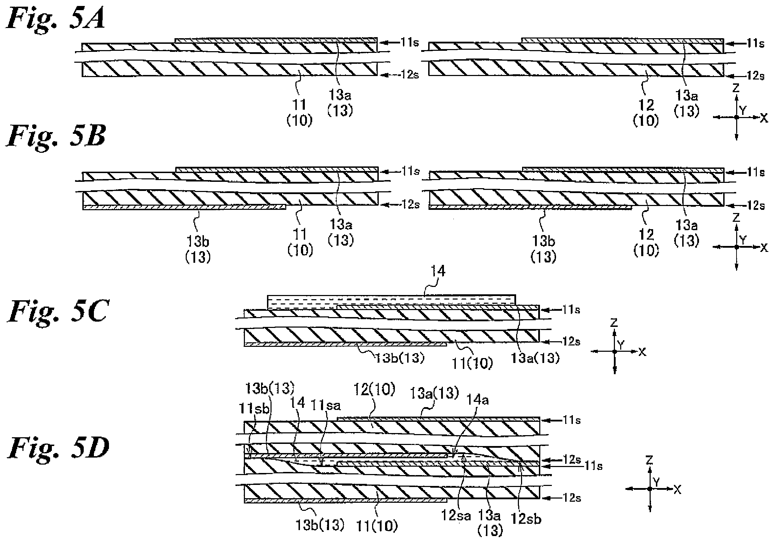

Next, an exemplary method for manufacturing the power generation element 1 will be described. Fig. 4 includes flowcharts illustrating an exemplary method for manufacturing the power generation element 1 in the first embodiment. Fig. 5 includes schematic cross-sectional views illustrating the exemplary method for manufacturing the power generation element 1 in the first embodiment.

The method for manufacturing the power generation element 1 includes, for example, as illustrated in Fig. 4A, a first electrode portion formation step S110, a second electrode portion formation step S120, an intermediate portion formation step S130, and a joining step S140.

### <First Electrode Portion Formation Step S110>

In the first electrode portion formation step S110, for example, as illustrated in Fig. 5A, the first electrode portion 13a is formed on the first principal surface 11s of the substrate 10. For example, as illustrated in Fig. 2A, the first electrode portion 13a is formed in a quadrilateral shape viewed in the first direction Z. In the first electrode portion formation step S110, for example, one first electrode portion 13a is formed on the first principal surface 11s of each of the first substrate portion 11 and the second substrate portion 12 preliminarily separated, and additionally, for example, a plurality of the first electrode portions 13a may be formed on the first principal surface 11s.

### <Second Electrode Portion Formation Step S120>

In the second electrode portion formation step S120, for example, as illustrated in Fig. 5B, the second electrode portion 13b is formed on the second principal surface 12s of the substrate 10. For example, similarly to the first electrode portion 13a, the second electrode portion 13b is formed in a quadrilateral shape viewed in the first direction Z. In the second electrode portion formation step S120, for example, one second electrode portion 13b is formed on the second principal surface 12s of each of the first substrate portion 11 and the second substrate portion 12 preliminarily separated, and additionally, a plurality of the second electrode portions 13b may be formed on the second principal surface 12s.

An order of performing the first electrode portion formation step S110 and the second electrode portion formation step S120 is appropriately set. In the first electrode portion formation step S110 and the second electrode portion formation step S120, for example, a screen-printing method is used to form each of the electrode portions 13a, 13b, and additionally, for example, a sputtering method, an evaporation method, an inkjet method, and a spray application method may be used to form each of the electrode portions 13a, 13b. For example, platinum is used as the first electrode portion 13a and aluminum is used as the second electrode portion 13b, and additionally, the respective above-described materials may be used.

In each of the electrode portion formation steps S110, S120, the wettability to the solvent 142 may be increased by, for example, performing a plasma treatment or the like to a surface of at least any of the electrode portions 13a, 13b. This surface treatment is performed, for example, so as to have the wettability of the respective electrode portions 13a, 13b higher than the wettability of the respective principal surfaces 11s, 12s. Accordingly, in the intermediate portion formation step S130 described later, the intermediate portion 14 can be easily formed on each of the electrode portions 13a, 13b.

### <Intermediate Portion Formation Step S130>

In the intermediate portion formation step S130, for example, as illustrated in Fig. 5C, the intermediate portion 14 is formed on a part of the first electrode portion 13a (for example, the first electrode portion 13a formed on the first substrate portion 11). At this time, for example, the intermediate portion 14 may be integrally formed from the first electrode portion 13a to the first principal surface 11s. In the intermediate portion formation step S130, for example, the intermediate portion 14 may be formed on a part of the second electrode portion 13b (for example, the second electrode portion 13b formed on the second substrate portion 12).

At this time, for example, when the first electrode portion 13a has the high wettability to the solvent 142 included in the intermediate portion 14 compared with the first principal surface 11s, the solvent 142 easily spreads over the first electrode portion 13a while being less likely to spread over the outer peripheral side of the first principal surface 11s. Therefore, the intermediate portion 14 is less likely to flow out from the first principal surface 11s, and especially, it can be avoided to form the intermediate portion 14 on the joint surface 11sb joined in the joining step S140 described later. For example, the second electrode portion 13b may have the high wettability to the solvent 142 compared with the second principal surface 12s.

In the intermediate portion formation step S130, for example, the intermediate portion 14 is formed using a screen-printing method, and additionally, for example, an inkjet method and a spray application method may be used to form the intermediate portion 14. As the intermediate portion 14, for example, the solvent 142 in which the nanoparticles 141 are preliminarily dispersed is used.

### <Joining Step S140>

In the joining step S140, for example, as illustrated in Fig. 5D, viewed in the first direction Z, the first electrode portion 13a formed on the first principal surface 11s of the first substrate portion 11 and the second electrode portion 13b formed on the second principal surface 12s of the second substrate portion 12 are joined so as to be overlapped. In the joining step S140, the first substrate portion 11 and the second substrate portion 12 are joined in a state where the first electrode portion 13a formed on the first principal surface 11s of the first substrate portion 11 and the second electrode portion 13b formed on the second principal surface 12s of the second substrate portion 12 are separated in the first direction Z via the intermediate portion 14.

In the joining step S140, for example, as illustrated in Fig. 1, the joining of the first substrate joint surface 11sbs and the second substrate joint surface 12sbs, the first electrode joint surface 11sbm and the second electrode portion 13b formed on the second substrate portion 12, and the first electrode portion 13a formed on the first substrate portion 11 and the second electrode joint surface 12sbm are each made. At this time, the first separated surface 11sa and the second separated surface 12sa are mutually separated.

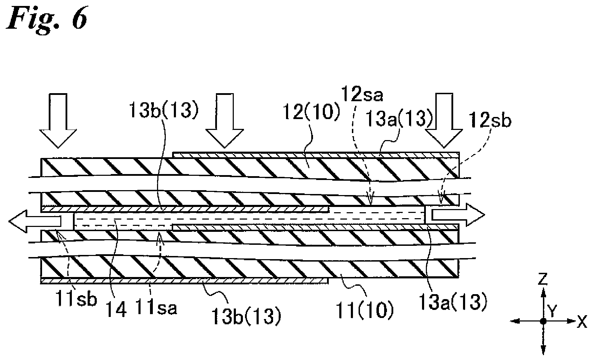

In the joining step S140, for example, a direct joining method is used to join the respective substrate portions 11, 12. In the joining step S140, a surface cleaning using a plasma treatment or the like is performed to a portion (surfaces corresponding to the respective joint surfaces 11sb, 12sb) at which the substrate portions 11, 12 are mutually joined. Subsequently, for example, as illustrated in Fig. 6, a force is uniformly applied to the second substrate portion 12 arranged above the first substrate portion 11 via the intermediate portion 14 (arrows along the first direction Z in Fig. 6). Subsequently, the surfaces corresponding to the respective joint surfaces 11sb, 12sb and parts of the respective electrode portions 13a, 13b are directly joined, thereby allowing obtaining the structure illustrated in Fig. 5D, for example.

For example, by decompressing the space between the substrate portions 11 and 12 (arrows along the second direction X in Fig. 6) before applying the force to the second substrate portion 12, air and the like can be removed from inside the gap portion 14a, thereby allowing easily filling inside the gap portion 14a with the intermediate portion 14. By removing the air and the like from the gap portion 14a, the deterioration of the power generation element 1 caused by the air and the like can be suppressed.

Since the interelectrode gap depends on the film thickness of the intermediate portion 14, by adjusting the film thickness forming the intermediate portion 14, the size of the interelectrode gap can be controlled.

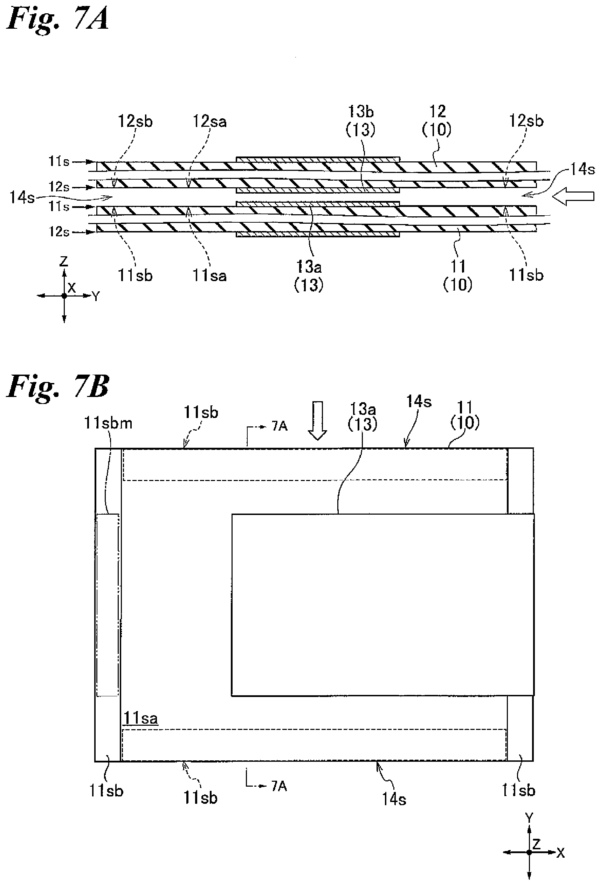

For example, as illustrated in Fig. 4B, the intermediate portion formation step S130 may be performed after performing the joining step S140. In this case, for example, as illustrated in Fig. 7, in the joining step S140, the side surface sides of the respective principal surfaces 11s, 12s are joined along one direction (third direction Y in Fig. 7B). At this time, for example, joining of any of the principal surfaces 11s, 12s and any of the electrode portions 13a, 13b may be included. Accordingly, a space 14s opening in the third direction Y is formed between the joint surfaces 11sb and 12sb. Fig. 7A is a schematic cross-sectional view taken along 7A-7A in Fig. 7B, and illustrates the space 14s formed between the respective substrate portions 11, 12.

Subsequently, in the intermediate portion formation step S130, the intermediate portion 14 is formed on the respective electrode portions 13a, 13b via the space 14s. The intermediate portion 14 is filled between the electrode portions 13a and 13b, and between the separated surfaces 11sa and 12sa by, for example, a capillarity (capillary force).

Subsequently, by joining the side surface sides of the respective principal surfaces 11s, 12s along another direction (a pair of dashed line parts along the second direction X in Fig. 7B) so as to surround the respective electrode portions 13a, 13b, the structure, for example, illustrated in Fig. 5D can be obtained.

By performing each of the above-described steps S110 to S140, the power generation element 1 in the first embodiment is formed.

The joining step S140 may include, for example, a connection wiring formation step in which the first connection wiring 15a in contact with the first electrode portion 13a and the second connection wiring 15b in contact with the second electrode portion 13b, which extend along the side surfaces of the substrate 10, are each formed after the joining of the respective substrate portions 11, 12. In this case, by connecting the terminal 101 and the wiring 102 to the connection wiring 15 and installing the load R after forming the power generation element 1, the power generation device 100 can be formed.

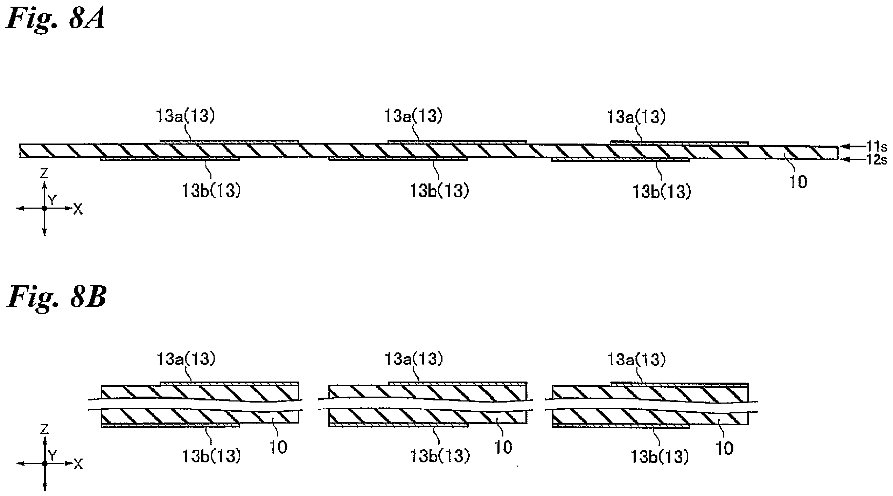

For example, as illustrated in Fig. 8A, in the first electrode portion formation step S110, a plurality of the first electrode portions 13a may be formed on the first principal surface 11s of one substrate 10. In the second electrode portion formation step S120, a plurality of the second electrode portions 13b may be formed on the second principal surface 12s of one substrate 10.

In this case, for example, as illustrated in Fig. 8B, the substrate 10 is divided for each pair of the electrode portions 13a, 13b after performing the respective electrode portion formation steps S110, S120, and additionally, for example, the substrate 10 may be divided for each pair of the electrode portions 13a, 13b after performing the joining step S140 and the like. Accordingly, the time spent for one power generation element 1 in the manufacture of the power generation element 1 can be shortened. Application to a continuous production process such as roll-to-roll also becomes possible, and the time spent for one in the manufacture can be further shortened. The substrates 10 divided after forming the electrode portions 13a, 13b can be used for both of the first substrate portion 11 and the second substrate portion 12.

According to the embodiment, the first principal surface 11s of the first substrate portion 11 includes the first separated surface 11sa that is in contact with the first electrode portion 13a provided on the first substrate portion 11 and separated from the second substrate portion 12, and the first joint surface 11sb that is provided to be continuous with the first separated surface 11sa, separated from the first electrode portion 13a provided on the first substrate portion 11, and in contact with the second substrate portion 12. The second principal surface 12s of the second substrate portion 12 includes the second separated surface 12sa that is in contact with the second electrode portion 13b provided on the second substrate portion 12 and separated from the first substrate portion 11, and the second joint surface 12sb that is provided to be continuous with the second separated surface 12sa, separated from the second electrode portion 13b provided on the second substrate portion 12, and in contact with the first substrate portion 11. That is, the intermediate portion 14 that can be formed by joining the principal surfaces 11s and 12s on which the electrode portions 13a, 13b are provided, respectively is interposed, thereby forming the interelectrode gap. Therefore, the need for additionally providing a support member or the like is eliminated, and the variation of the interelectrode gap can be suppressed. Accordingly, the stabilized generation amount of the electric energy can be achieved.

According to the embodiment, the electrode portions 13 are provided on the first principal surface 11s and the second principal surface 12s. That is, the substrate 10 is sandwiched between the electrode portions 13. Therefore, when the power generation element 1 of the stacked structure is provided, the thickness in the first direction Z can be suppressed. Accordingly, downsizing of the power generation element 1 can be ensured.

According to the embodiment, the first electrode portions 13a are provided on the first principal surface 11s of the first substrate portion 11 and the first principal surface 11s of the second substrate portion 12. The second electrode portions 13b are provided on the second principal surface 12s of the first substrate portion 11 and the second principal surface 12s of the second substrate portion 12. That is, the substrate portions 11, 12 are each provided with the first electrode portion 13a and the second electrode portion 13b while sandwiching the substrate portions 11, 12. Therefore, when the power generation element 1 of the stacked structure is formed, it can be easily achieved. Accordingly, facilitation of the manufacturing process can be ensured.

According to the embodiment, viewed in the first direction Z, the intermediate portion 14 is surrounded by the first joint surface 11sb and the second joint surface 12sb. Therefore, the closed space (gap portion 14a) surrounding the intermediate portion 14 can be formed by the joint surfaces 11sb, 12sb of the principal surfaces 11s, 12s on which the electrode portions 13a, 13b are provided, respectively. Accordingly, leaking out or the like of the intermediate portion 14 can be suppressed without forming another configuration on the substrate 10.

According to the embodiment, the first connection wiring 15a and the second connection wiring 15b are provided on the side surfaces of the substrate 10. Therefore, the connection wirings 15a, 15b to be electrically connected to the electrode portions 13 a, 13b, respectively can be easily provided. Accordingly, facilitation of the manufacturing process can be ensured. Even in a case where the connection wirings 15a, 15b are each deteriorated in accordance with the use of the power generation element 1, the repair can be easily made.

According to the embodiment, the first connection wiring 15a extends in the first direction Z, and is in contact with a plurality of the first electrode portions 13a. The second connection wiring 15b extends in the first direction Z, and is in contact with a plurality of the second electrode portions 13b. Therefore, also in the case where the plurality of respective substrate portions 11, 12 are stacked, the connection wirings 15a, 15b to be electrically connected to the electrode portions 13a, 13b, respectively can be easily provided. Accordingly, facilitation of the manufacturing process can be ensured. Stress concentration parts of the respective connection wirings 15a, 15b can be decreased, thus allowing suppressing wire disconnection and the like of the respective connection wirings 15a, 15b.

According to the embodiment, the side surface of the first electrode portion 13a provided on the first substrate portion 11 and the side surface of the second electrode portion 13b provided on the second substrate portion 12 are in contact with the intermediate portion 14. Therefore, the electrons e can be moved via the side surfaces of the respective electrode portions 13a, 13b in addition to the opposing surfaces of the respective electrode portions 13a, 13b. Accordingly, the generation amount of the electric energy can be increased.

According to the embodiment, at least any of the first principal surface 11s of the first substrate portion 11 and the second principal surface 12s of the second substrate portion 12 is formed in the curved shape. Therefore, a portion such as a protrusion to which a stress is locally concentrated is not formed. Accordingly, a damage due to an impact from outside can be suppressed. When a film-shaped flexible material is used as the substrate 10 and formed in a curved-shape, joining the substrate portions 11, 12 can be easily achieved.

According to the embodiment, the first electrode portion 13a provided on the first substrate portion 11 has the high wettability to the intermediate portion 14 compared with the first principal surface 11s of the first substrate portion 11. Therefore, the nanoparticles 141 dispersed in the solvent 142 included in the intermediate portion 14 can be easily kept between the electrode portions 13a and 13b. Accordingly, the reduction over time in generation amount of the electric energy can be suppressed.

According to the embodiment, the first joint surface 11sb includes the first substrate joint surface 1 lsbs in contact with the second joint surface 12sb, and the first electrode joint surface 11sbm in contact with the second electrode portion 13b provided on the second substrate portion 12. The second joint surface 12sb includes the second substrate joint surface 12sbs in contact with the first substrate joint surface 1 lsbs, and the second electrode joint surface 12sbm in contact with the first electrode portion 13a provided on the first substrate portion 11. Therefore, the areas in which the respective electrode portions 13a, 13b are provided on the substrates 10 can be increased, thus allowing increasing the opposing areas of the respective electrode portions 13a, 13b. Accordingly, the generation amount of the electric energy can be increased.

According to the embodiment, for example, along the first direction Z, the thickness T1a of the first substrate portion 11 starting from the first separated surface 11sa is equal to the thickness T1b of the first substrate portion 11 starting from the first joint surface 11sb. Along the first direction Z, the thickness T2a of the second substrate portion 12 starting from the second separated surface 12sa is equal to the thickness T2b of the second substrate portion 12 starting from the second joint surface 12sb. Therefore, the process of partially removing the respective substrate portions 11, 12, or the like is not performed, thus allowing suppressing local reduction of proof strengths of the respective substrate portions 11, 12. Accordingly, the deterioration of the respective substrate portions 11, 12 can be suppressed. Additionally, it is not necessary to perform the process of partially removing the respective substrate portions 11, 12, a process of stacking an additional configuration on the substrate 10, or the like, thus allowing ensuring reduction of the manufacturing process.

According to the embodiment, in the joining step S140, the first substrate portion 11 and the second substrate portion 12 are joined so as to be overlapped viewed in the first direction Z. At this time, the first principal surface 11s of the first substrate portion 11 includes the first separated surface 11sa that is in contact with the first electrode portion 13a formed on the first substrate portion 11 and separated from the second substrate portion 12, and the first joint surface 11sb that is formed to be continuous with the first separated surface 11sa, separated from the first electrode portion 13a formed on the first substrate portion 11, and in contact with the second substrate portion 12. The second principal surface 12s of the second substrate portion 12 includes the second separated surface 12sa that is in contact with the second electrode portion 13b formed on the second substrate portion 12 and separated from the first substrate portion 11, and the second joint surface 12sb that is formed to be continuous with the second separated surface 12sa, separated from the second electrode portion 13b formed on the second substrate portion 12, and in contact with the first substrate portion 11. That is, the intermediate portion 14 that can be formed by joining the principal surfaces 11s and 12s on which the electrode portions 13a, 13b are formed, respectively is interposed, thereby forming the interelectrode gap. Therefore, the need for additionally providing a support member or the like is eliminated, and the variation of the interelectrode gap can be suppressed. Accordingly, the stabilized generation amount of the electric energy can be achieved.

According to the embodiment, the first electrode portion 13a is formed on the first principal surface 11s, and the second electrode portion 13b is formed on the second principal surface 12s of the substrate 10. That is, the substrate 10 is sandwiched between the respective electrode portions 13a, 13b. Therefore, when the power generation element 1 of the stacked structure is provided, the thickness in the first direction Z can be suppressed. Accordingly, downsizing of the power generation element 1 can be ensured.

According to the embodiment, the joining step S140 is performed in the state where the pressure between the first substrate portion 11 and the second substrate portion 12 is reduced. Therefore, air and the like can be removed from inside the gap portion 14a in which the interelectrode gap is formed, thereby allowing easily filling inside the gap portion 14a with the intermediate portion 14. Accordingly, facilitating the manufacturing process can be ensured.

### (First Embodiment: Modification of Substrate 10)

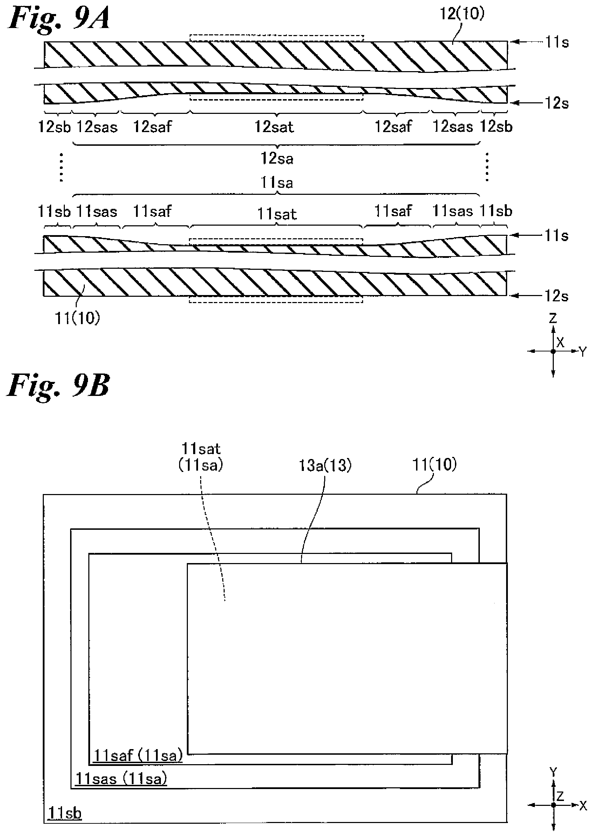

Next, a modification of the substrate 10 in the first embodiment will be described. Fig. 9 includes schematic diagrams illustrating the modification of the substrate 10 in the first embodiment. Fig. 9A is a schematic cross-sectional view illustrating the modification of the substrate 10 in the first embodiment, and Fig. 9B is a schematic plan view of the power generation element 1 including the modification of the substrate 10 in the first embodiment. Fig. 9A corresponds to the schematic cross-sectional view of Fig. 1C, and Fig. 9B corresponds to the schematic plan view of Fig. 2A.

The difference between the above-described embodiment and the modification is that the first separated surface 11sa includes a contact surface 11sat, a first surface 11saf, and a second surface 11sas. For configurations similar to the above-described configurations, descriptions will be omitted.

As illustrated in Fig. 9, the contact surface 11sat is in contact with the first electrode portion 13a. For example, viewed in the first direction Z, the contact surface 11sat means a part completely overlapping the first electrode portion 13a in the first principal surface 11s. The first surface 11saf is provided to be continuous with the contact surface 11sat, and has a portion provided outside the contact surface 11sat. The first surface 11saf is provided between the contact surface 11sat and the second surface 11sas. The second surface 11sas is provided to be continuous with the first surface 11saf, and provided outside the first surface 11saf. The second surface 11sas is provided between the first surface 11saf and the joint surface 11sb.

The first surface 11saf has a high wettability to the solvent 142 compared with the second surface 11sas. Therefore, the solvent 142 easily spreads over the first surface 1 1saf compared with the second surface 11sas, and oozing of the solvent 142 from the respective joint surfaces 11sb, 12sb can be suppressed.

The difference in wettability between the first surface 1 1saf and the second surface 11sas can be achieved by, for example, changing the surface energy of at least any of the first surface 11saf and the second surface 11sas using a plasma treatment method. At least any of the first surface 11saf and the second surface 11sas may have a moth-eye structure formed by, for example, a nano-imprint method.

For example, as illustrated in Fig. 9A, similarly to the above-described first separated surface 11sa, the second separated surface 12sa may include a contact surface 12sat, a first surface 12saf, and a second surface 12sas. Also in this case, the oozing of the solvent 142 from the respective joint surfaces 11sb, 12sb can be suppressed.

Especially, in a case where the electrode portions 13a, 13b have the high wettability to the solvent 142 compared with the first surfaces 11saf, 12saf, respectively when the separated surfaces 11sa, 12sa include the contact surfaces 11sat, 12sat, the first surfaces 11saf, 12saf, and the second surfaces 11sas, 12sas, respectively, the solvent 142 can be stably held between the electrode portions 13a and 13b.

### (First Embodiment: Modification of Method for Manufacturing Power Generation Element 1)

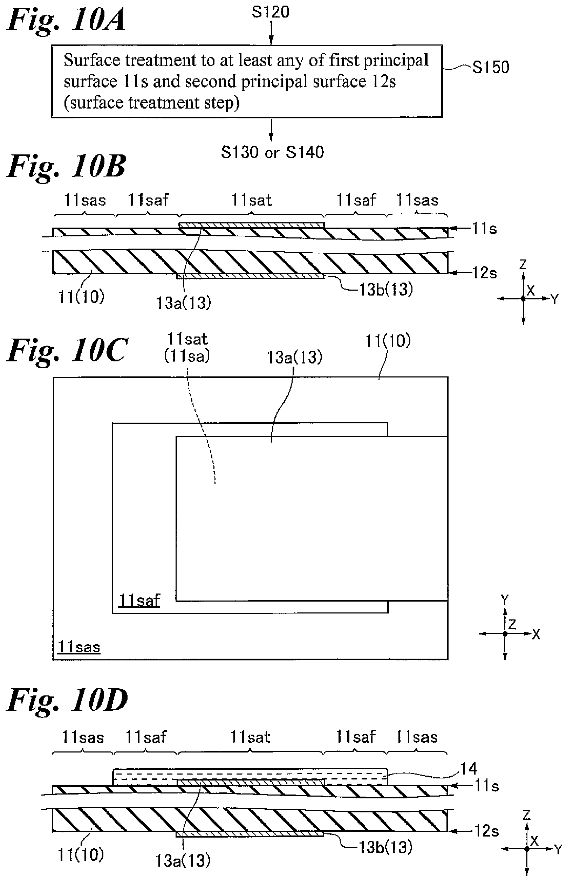

Next, a modification of the method for manufacturing the power generation element 1 will be described. Fig. 10A is a flowchart illustrating the modification of the method for manufacturing the power generation element 1 in the first embodiment, and Fig. 10B to Fig. 10D are schematic diagrams illustrating the modification of the method for manufacturing the power generation element 1 in the first embodiment.

The difference between the above-described embodiment and the modification is that a surface treatment step S150 is further included. For steps similar to the above-described configurations, descriptions will be omitted.

### <Surface Treatment Step S150>

In the surface treatment step S150, for example, a surface treatment is performed to the first principal surface 11s positioned in the peripheral area of the first electrode portion 13a formed on the first substrate portion 11 before the intermediate portion formation step S130 and the joining step S140. In the surface treatment step S150, for example, as illustrated in Fig. 10B and Fig. 10C, the first surface 11saf subjected to the surface treatment and the second surface 11sas not subjected to the surface treatment are formed. At this time, the surface treatment is performed so as to cause the first surface 11saf to have the high wettability to the solvent 142 compared with the second surface 11sas. Note that, for example, the surface treatment may be performed to the second surface 11sas so as to make the wettability of the second surface 11sas low.

In the surface treatment step S150, for example, the surface treatment is performed to the first principal surface 11s using a plasma treatment method. Note that, in the surface treatment step S150, for example, similarly to the first principal surface 11s, the surface treatment may be performed to the second principal surface 12s.

Subsequently, each of the above-described steps S130, S140 are performed, thus forming the power generation element 1 in the first embodiment. By performing the surface treatment step S150, for example, as illustrated in Fig. 10D, the state where the intermediate portion 14 is less likely to spread to the second surface 11sas side can be kept in the intermediate portion formation step S130, thus allowing easily keeping the intermediate portion 14 on the first electrode portion 13a. The surface treatment step S150 may be performed, for example, before each of the electrode portion formation steps S110, S120.

According to the modification, the first surfaces 11saf, 12saf have the high wettability to the intermediate portion 14 (solvent 142) compared with the second surfaces 11sas, 12sas. Therefore, the oozing of the solvent 142 from the respective joint surfaces 11sb, 12sb can be suppressed. Accordingly, the reduction over time in the amount of the solvent 142 can be suppressed.

According to the modification, in the surface treatment step S150, the surface treatment is performed to the first principal surface 11s positioned in the peripheral area of the first electrode portion 13a formed on the first substrate portion 11. Therefore, when the intermediate portion formation step S130 is performed, the intermediate portion 14 can be easily kept on the first electrode portion 13a. Accordingly, the intermediate portion 14 can be easily formed.

### (First Embodiment: First Modification of Power Generation Element 1)

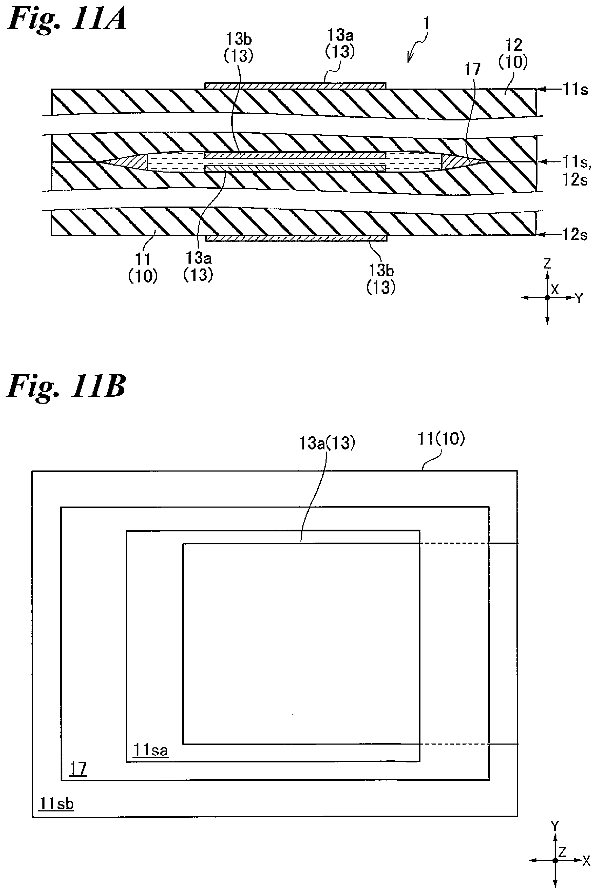

Next, the first modification of the power generation element 1 in the first embodiment will be described. Fig. 11 includes schematic diagrams illustrating the first modification of the power generation element 1 in the first embodiment. Fig. 11A is a schematic cross-sectional view illustrating the first modification of the power generation element 1 in the first embodiment, and Fig. 11B is a schematic plan view illustrating the first modification of the power generation element 1 in the first embodiment. Fig. 11B corresponds to the schematic plan view of Fig. 2A.

The difference between the above-described embodiment and the first modification is that a sealing portion 17 is further included. For configurations similar to the above-described configurations, descriptions will be omitted.

For example, as illustrated in Fig. 11, the sealing portion 17 is provided inside the gap portion 14a. The sealing portion 17 is provided between the electrode portions 13a, 13b and the joint surfaces 11sb, 12sb, respectively in the gap portion 14a. The sealing portion 17 surrounds, for example, the intermediate portion 14. The sealing portion 17 is in contact with and surrounded by each of the joint surfaces 11sb, 12sb.

As the sealing portion 17, for example, an insulating resin is used, and the exemplary insulating resin can include a fluorine-based insulating resin. In addition, as the sealing portion 17, for example, a metal such as aluminum may be used. By using a metal as the sealing portion 17, the deterioration of the power generation element 1 caused by a gas such as water vapor can be suppressed.

According to the first modification, the sealing portion 17 is provided between the first electrode portion 13a provided on the first substrate portion 11 and the first joint surface 11sb and between the second electrode portion 13b provided on the second substrate portion 12 and the second joint surface 12sb, and surrounds the intermediate portion 14. Therefore, the oozing of the intermediate portion 14 (solvent 142) from the respective joint surfaces 11sb, 12sb can be suppressed. Accordingly, the reduction over time in the amount of the solvent 142 can be suppressed.

### (First Embodiment: Second Modification of Power Generation Element 1)

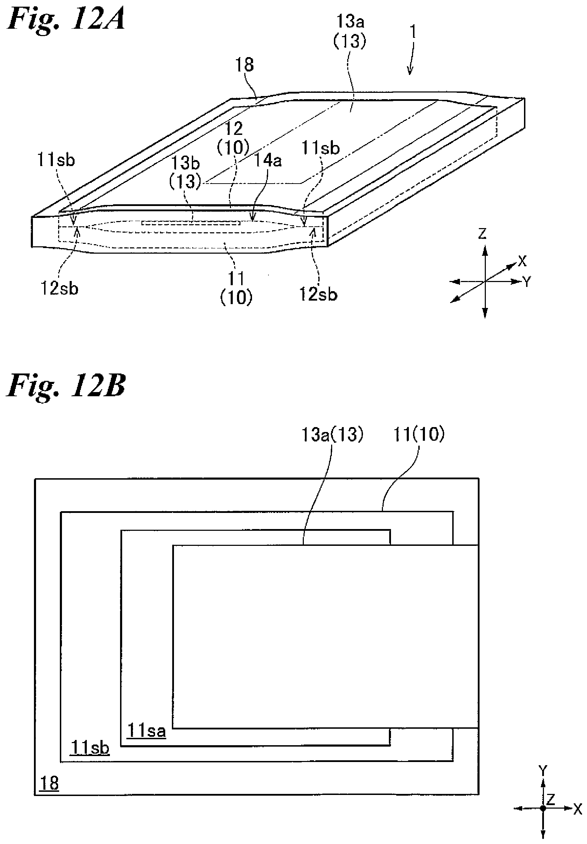

Next, the second modification of the power generation element 1 in the first embodiment will be described. Fig. 12 includes schematic diagrams illustrating the second modification of the power generation element 1 in the first embodiment. Fig. 12A is a schematic perspective view illustrating the second modification of the power generation element 1 in the first embodiment, and Fig. 12B is a schematic plan view illustrating the second modification of the power generation element 1 in the first embodiment. Fig. 12B corresponds to the schematic plan view of Fig. 2A.

The difference between the above-described embodiment and the second modification is that a protective film 18 is further included. For configurations similar to the above-described configurations, descriptions will be omitted.

For example, as illustrated in Fig. 12, the protective film 18 at least surrounds the side surface of the first substrate portion 11 and the side surface of the second substrate portion 12. For example, the protective film 18 is in contact with the respective connection wirings 15a, 15b provided on the side surfaces of the respective substrate portions 11, 12, and surrounds them. The protective film 18 may cover, for example, the entire substrate 10.

As the protective film 18, for example, an insulating resin is used, and the exemplary insulating resin can include a fluorine-based insulating resin. In addition, as the protective film 18, for example, a metal such as aluminum may be used. By using a metal as the protective film 18, the deterioration of the power generation element 1 caused by a gas such as water vapor can be suppressed.

According to the second modification, the protective film 18 at least surrounds the side surface of the first substrate portion 11 and the side surface of the second substrate portion 12. Therefore, the deterioration of the substrate 10 due to an external factor can be suppressed. Accordingly, the time deterioration of the power generation element 1 can be suppressed.

According to the second modification, the oozing of the solvent 142 from the respective joint surfaces 11sb, 12sb can be suppressed. Accordingly, the reduction over time in the amount of the solvent 142 can be suppressed.

### (First Embodiment: Third Modification of Power Generation Element 1)

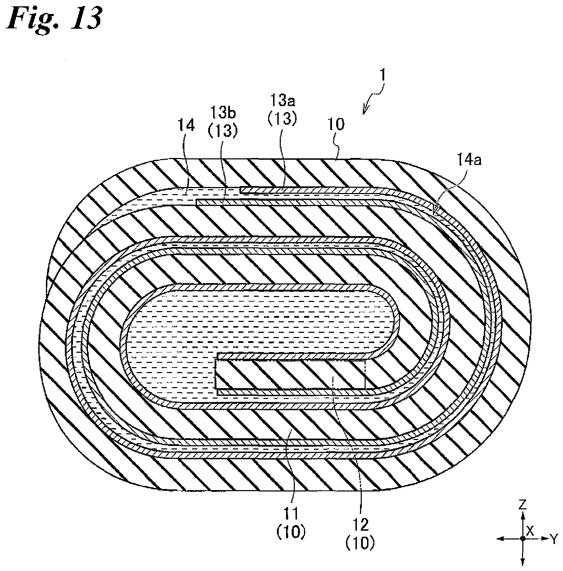

Next, the third modification of the power generation element 1 in the first embodiment will be described. Fig. 13 is a schematic cross-sectional view illustrating the third modification of the power generation element 1 in the first embodiment.

The difference between the above-described embodiment and the third modification is that a substrate 10 wound in a roll shape is used. For configurations similar to the above-described configurations, descriptions will be omitted.

For example, as illustrated in Fig. 13, the gap portion 14a is formed between respective layers of the substrate 10 wound in the roll shape, and the respective electrode portions 13a, 13b and the intermediate portion 14 are provided. The electrode portions 13a, 13b are each provided along a direction in which the substrate 10 extends in the roll shape.

The substrate 10 wound in the roll shape is wound around a columnar or cylindrically-shaped shaft member (not illustrated), and additionally, may have a shape fixed by UV hardening or the like. A distal end portion in the wound outer side of the substrate 10 wound in the roll shape is joined in a wound state where the gap portion 14a is formed, and additionally, may be secured by an insulating sealing material or the like. The substrate 10 wound in the roll shape may be covered with, for example, the protective film 18 described above.

In the substrate 10, for example, the second substrate portion 12 is provided on an inner diameter side (two-dot chain line in Fig. 13) of the substrate 10 wound in the roll shape, and the first substrate portion 11 is provided on an outer diameter side of the substrate 10 wound in the roll shape. Viewed in the third direction Y, cross-sectional surfaces of the respective substrate portions 11, 12 are equal to the structure illustrated in Fig. 1A.

According to the third modification, the substrate 10 and the respective electrode portions 13a, 13b are wound in the roll shape, and the intermediate portion 14 is provided between the respective electrode portions 13a, 13b. Therefore, opposing areas of the respective electrode portions 13a, 13b can be tremendously increased. Accordingly, the generation amount of the electric energy can be increased.

### (Second Embodiment: Power Generation Device 100, Power Generation Element 1)

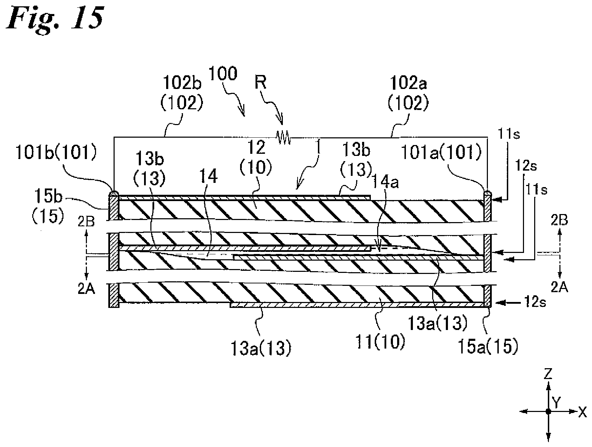

Next, a power generation device 100 and a power generation element 1 in the second embodiment will be described. Fig. 15 is a schematic cross-sectional view illustrating exemplary power generation device 100 and power generation element 1 in the second embodiment.

The difference between the above-described embodiment and the second embodiment is that different electrode portions 13a, 13b are provided on the substrate portions 11, 12, respectively. For configurations similar to the above-described configurations, descriptions will be omitted.

As illustrated in Fig. 15, the first electrode portions 13a are provided on the first principal surface 11s and the second principal surface 12s of the first substrate portion 11. That is, the first substrate portion 11 is sandwiched between a pair of the first electrode portions 13a. For example, viewed in the first direction Z, the pair of the first electrode portions 13a are provided to be overlapped. The pair of the first electrode portions 13a extend to one side surface of the first substrate portion 11, and are electrically connected to one another via the first connection wiring 15a.

The second electrode portions 13b are provided on the first principal surface 11s and the second principal surface 12s of the second substrate portion 12. That is, the second substrate portion 12 is sandwiched between a pair of the second electrode portions 13b. For example, viewed in the first direction Z, the pair of the second electrode portions 13b are provided to be overlapped. The pair of the second electrode portions 13b extend to one side surface of the second substrate portion 12, and are electrically connected to one another via the second connection wiring 15b.

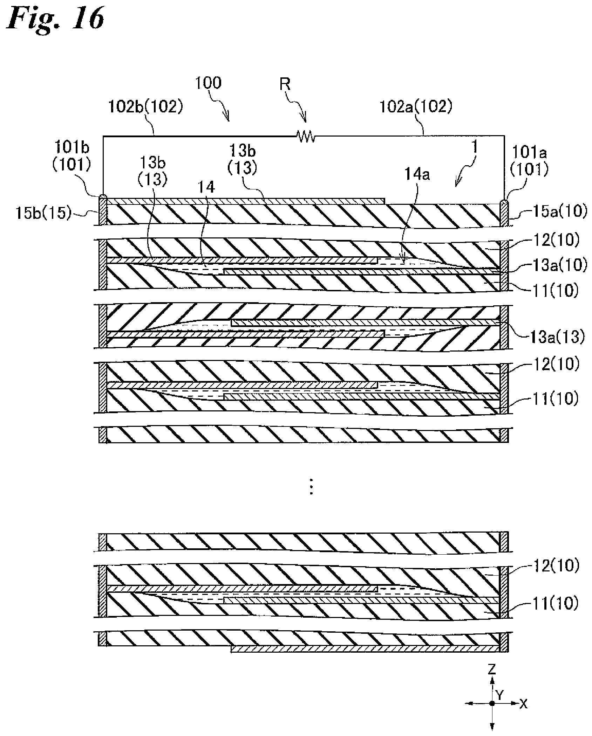

For example, as illustrated in Fig. 16, the power generation element 1 may have a structure in which the above-described configurations are stacked. In this case, the first connection wiring 15a extends in the first direction Z along the side surfaces of the stacked substrate portions 11, 12, and is in contact with the plurality of the first electrode portions 13a. The second connection wiring 15b is opposed to the first connection wiring 15a, extend in the first direction Z along the side surfaces of the stacked substrate portions 11, 12, and is in contact with the plurality of the second electrode portions 13b. The power generation device 100 may include the power generation element 1 of the above-described structure.

According to the embodiment, similarly to the above-described embodiment, the first principal surface 11s of the first substrate portion 11 includes the first separated surface 11sa that is in contact with the first electrode portion 13a provided on the first substrate portion 11 and separated from the second substrate portion 12, and the first joint surface 11sb that is provided to be continuous with the first separated surface 11sa, separated from the first electrode portion 13a provided on the first substrate portion 11, and in contact with the second substrate portion 12. The second principal surface 12s of the second substrate portion 12 includes the second separated surface 12sa that is in contact with the second electrode portion 13b provided on the second substrate portion 12 and separated from the first substrate portion 11, and the second joint surface 12sb that is provided to be continuous with the second separated surface 12sa, separated from the second electrode portion 13b provided on the second substrate portion 12, and in contact with the first substrate portion 11. That is, the intermediate portion 14 that can be formed by joining the principal surfaces 11s and 12s on which the electrode portions 13a, 13b are provided, respectively is interposed, thereby forming the interelectrode gap. Therefore, the need for additionally providing a support member or the like is eliminated, and the variation of the interelectrode gap can be suppressed. Accordingly, the stabilized generation amount of the electric energy can be achieved.

According to the embodiment, similarly to the above-described embodiment, the electrode portions 13 are provided on the first principal surface 11s and the second principal surface 12s. That is, the substrate 10 is sandwiched between the electrode portions 13. Therefore, when the power generation element 1 of the stacked structure is provided, the thickness in the first direction Z can be suppressed. Accordingly, downsizing of the power generation element 1 can be ensured.

According to the embodiment, the first electrode portions 13a are provided on the first principal surface 11s and the second principal surface 12s of the first substrate portion 11. The second electrode portions 13b are provided on the first principal surface 11s and the second principal surface 12s of the second substrate portion 12. That is, any of the first electrode portion 13a or the second electrode portion 13b is provided on each of the substrate portions 11, 12. Therefore, when one electrode portion 13a, 13b is formed, a possibility of forming to be in contact with the other electrode portion 13a, 13b can be suppressed. Accordingly, yield improvement in manufacturing the power generation element 1 can be ensured.

### (Third Embodiment: Electronic Apparatus 500)

### <Electronic Apparatus 500>

The power generation element 1 and the power generation device 100 described above can be mounted to, for example, an electronic apparatus. The following describes some embodiments of the electronic apparatus.

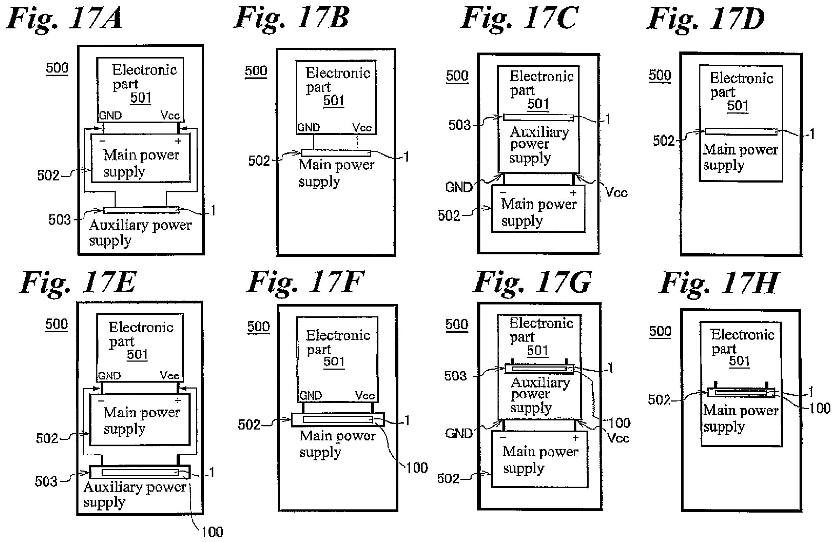

Fig. 17A to Fig. 17D are schematic block diagrams illustrating examples of the electronic apparatus 500 including the power generation element 1. Fig. 17E to Fig. 17H are schematic block diagrams illustrating examples of the electronic apparatus 500 including the power generation device 100 with the power generation element 1.

As illustrated in Fig. 17A, the electronic apparatus 500 (electric product) includes an electronic part 501 (electronic component), a main power supply 502, and an auxiliary power supply 503. The electronic apparatus 500 and the electronic part 501 are each electrical equipment (electrical device).

The electronic part 501 is driven using the main power supply 502 as a power supply. As the exemplary electronic part 501, for example, a CPU, a motor, a sensor terminal, an illumination, and the like can be included. For example, when the electronic part 501 is a CPU, the electronic apparatus 500 includes an electronic apparatus controllable by a built-in master (CPU). When the electronic part 501 includes, for example, at least one of a motor, a sensor terminal, an illumination, and the like, the electronic apparatus 500 includes an external master or an electronic apparatus controllable by a human.

The main power supply 502 is, for example, a battery. The battery includes a rechargeable battery. A positive terminal (+) of the main power supply 502 is electrically connected to a Vcc terminal (Vcc) of the electronic part 501. A negative terminal (-) of the main power supply 502 is electrically connected to a GND terminal (GND) of the electronic part 501.

The auxiliary power supply 503 is the power generation element 1. The power generation element 1 includes at least one of the above-described power generation elements 1. An anode (for example, first electrode portion 13a) of the power generation element 1 is electrically connected to the GND terminal (GND) of the electronic part 501, the negative terminal (-) of the main power supply 502, or a wiring connecting the GND terminal (GND) and the negative terminal (-). A cathode (for example, second electrode portion 13b) of the power generation element 1 is electrically connected to the Vcc terminal (Vcc) of the electronic part 501, the positive terminal (+) of the main power supply 502, or a wiring connecting the Vcc terminal (Vcc) and the positive terminal (+). In the electronic apparatus 500, the auxiliary power supply 503 is, for example, used together with the main power supply 502, and can be used as a power supply for assisting the main power supply 502 and a power supply to back up the main power supply 502 when the capacity of the main power supply 502 is exhausted. When the main power supply 502 is a rechargeable battery, the auxiliary power supply 503 can be further used as a power supply for charging the battery.

As illustrated in Fig. 17B, the main power supply 502 may be the power generation element 1. The anode of the power generation element 1 is electrically connected to the GND terminal (GND) of the electronic part 501. The cathode of the power generation element 1 is electrically connected to the Vcc terminal (Vcc) of the electronic part 501. The electronic apparatus 500 illustrated in Fig. 17B includes the power generation element 1 used as the main power supply 502, and the electronic part 501 that can be driven using the power generation element 1. The power generation element 1 is an independent power supply (for example, off-grid power supply). Therefore, the electronic apparatus 500 can be, for example, a free-standing type (standalone type). Moreover, the power generation element 1 is an energy harvesting type (energy harvesting type). The electronic apparatus 500 illustrated in Fig. 17B does not require battery replacement.

As illustrated in Fig. 17C, the electronic part 501 may include the power generation element 1. The anode of the power generation element 1 is electrically connected to, for example, a GND wiring of a circuit substrate (illustration is omitted). The cathode of the power generation element 1 is electrically connected to, for example, a Vcc wiring of the circuit substrate (illustration is omitted). In this case, the power generation element 1 can be used as, for example, the auxiliary power supply 503 of the electronic part 501.

As illustrated in Fig. 17D, when the electronic part 501 includes the power generation element 1, the power generation element 1 can be used as, for example, the main power supply 502 of the electronic part 501.

As illustrated in each of Fig. 17E to Fig. 17H, the electronic apparatus 500 may include the power generation device 100. The power generation device 100 includes the power generation element 1 as a source of the electric energy.

In the embodiment illustrated in Fig. 17D, the electronic part 501 includes the power generation element 1 used as the main power supply 502. Similarly, in the embodiment illustrated in Fig. 17H, the electronic part 501 includes the power generation device 100 used as a main power supply. In these embodiments, the electronic part 501 includes an independent power supply. Therefore, for example, the electronic part 501 can be a free-standing type. The electronic part 501 of the free-standing type can be effectively used for an electronic apparatus, for example, in which a plurality of electronic parts are included and at least one electronic part is separated from the other electronic parts. An exemplary electronic apparatus 500 is a sensor. The sensor includes a sensor terminal (slave) and a controller (master) separated from the sensor terminal. Each of the sensor terminal and the controller is the electronic part 501. The sensor terminal including the power generation element 1 or the power generation device 100 is a sensor terminal of the free-standing type, thus eliminating the need for wired electric power supply. Since the power generation element 1 or the power generation device 100 is the energy harvesting type, the battery replacement is not required. The sensor terminal can be regarded as one of the electronic apparatuses 500. The sensor terminal regarded as the electronic apparatus 500 further includes, for example, an IoT wireless tag and the like in addition to a sensor terminal of a sensor.

It is common in the embodiments illustrated in respective Fig. 17A to Fig. 17H that the electronic apparatus 500 includes the power generation element 1 converting the thermal energy into the electric energy and the electronic part 501 configured to be driven using the power generation element 1 as a power supply.

The electronic apparatus 500 may be an autonomous type (autonomous type) including an independent power supply. An exemplary autonomous electronic apparatus can include, for example, a robot and the like. Furthermore, the electronic part 501 including the power generation element 1 or the power generation device 100 may be an autonomous type including an independent power supply. An exemplary autonomous electronic part can include, for example, a movable sensor terminal and the like.

While the embodiments of the present invention have been described above, these embodiments have been presented by way of examples only, and are not intended to limit the scope of the invention. For example, these embodiments can be embodied in combination as necessary. The present invention can be embodied in various novel embodiments in addition to the above-described embodiments. Therefore, for each of the above-described embodiments, various omissions, substitutions and changes can be made without departing from the gist of the invention. The accompanying claims and their equivalents cover such novel embodiments and modifications as would fall within the scope and spirit of the invention.

### DESCRIPTION OF REFERENCE SIGNS

- 1:: Power generation element
- 10:: Substrate
- 11:: First substrate portion
- 11s:: First principal surface
- 11sa:: First separated surface
- 11saf:: First surface
- 11sas:: Second surface
- 11sat:: Contact surface
- 11sb:: First joint surface
- 11sbm:: First electrode joint surface
- 11sbs:: First substrate joint surface
- 12:: Second substrate portion
- 12s:: Second principal surface
- 12sa:: Second separated surface
- 12saf:: First surface
- 12sas:: Second surface
- 12sat:: Contact surface
- 12sb:: Second joint surface
- 12sbm:: Second electrode joint surface
- 12sbs:: Second substrate joint surface
- 13a:: First electrode portion
- 13b:: Second electrode portion
- 14:: Intermediate portion
- 14a:: Gap portion
- 14s:: Space
- 15:: Connection wiring
- 17:: Sealing portion
- 18:: Protective film
- 100:: Power generation device
- 101:: Terminal
- 102:: Wiring
- 141:: Nanoparticle
- 142:: Solvent
- 500:: Electronic apparatus
- 501:: Electronic part
- 502:: Main power supply
- 503:: Auxiliary power supply
- R:: Load
- S110:: First electrode portion formation step
- S120:: Second electrode portion formation step
- S130:: Intermediate portion formation step
- S140:: Joining step
- S150:: Surface treatment step
- Z:: First direction
- X:: Second direction
- Y:: Third direction
- e:: Electron

## Claims

1. A power generation element that converts a thermal energy into an electric energy, comprising:
a substrate including mutually opposed first principal surface and second principal surface;
an electrode portion provided on the first principal surface and the second principal surface, the electrode portion including a first electrode portion and a second electrode portion, the second electrode portion having a work function different from a work function of the first electrode portion; and
an intermediate portion including nanoparticles having a work function between the work function of the first electrode portion and the work function of the second electrode portion, wherein
the substrate includes a first substrate portion and a second substrate portion that are mutually overlapped viewed in a first direction intersecting with the first principal surface and the second principal surface,
the intermediate portion is sandwiched between the first electrode portion provided on the first principal surface of the first substrate portion and the second electrode portion provided on the second principal surface of the second substrate portion,
the first principal surface of the first substrate portion includes:
a first separated surface that is in contact with the first electrode portion provided on the first substrate portion and separated from the second substrate portion; and
a first joint surface that is provided to be continuous with the first separated surface, separated from the first electrode portion provided on the first substrate portion, and in contact with the second substrate portion, and
the second principal surface of the second substrate portion includes:
a second separated surface that is in contact with the second electrode portion provided on the second substrate portion and separated from the first substrate portion; and
a second joint surface that is provided to be continuous with the second separated surface, separated from the second electrode portion provided on the second substrate portion, and in contact with the first substrate portion.

2. The power generation element according to claim 1, wherein
the first electrode portions are provided on the first principal surface of the first substrate portion and the first principal surface of the second substrate portion, and
the second electrode portions are provided on the second principal surface of the first substrate portion and the second principal surface of the second substrate portion.

3. The power generation element according to claim 1, wherein
the first electrode portions are provided on the first principal surface and the second principal surface of the first substrate portion, and
the second electrode portions are provided on the first principal surface and the second principal surface of the second substrate portion.

4. The power generation element according to any one of claims 1 to 3, wherein
the intermediate portion is surrounded by the first joint surface and the second joint surface viewed in the first direction.

5. The power generation element according to any one of claims 1 to 4, further comprising
a first connection wiring and a second connection wiring that are provided on side surfaces of the substrate and mutually opposed, wherein
the first connection wiring is in contact with the first electrode portion, and
the second connection wiring is in contact with the second electrode portion.

6. The power generation element according to claim 5, wherein
a plurality of the first substrate portions and a plurality of the second substrate portions are stacked in the first direction,
the first connection wiring extends in the first direction and is in contact with the plurality of first electrode portions, and
the second connection wiring extends in the first direction and is in contact with the plurality of second electrode portions.

7. The power generation element according to any one of claims 1 to 6, wherein
a side surface of the first electrode portion provided on the first substrate portion and a side surface of the second electrode portion provided on the second substrate portion are in contact with the intermediate portion.

8. The power generation element according to any one of claims 1 to 7, wherein
at least any of the first principal surface of the first substrate portion and the second principal surface of the second substrate portion is formed in a curved shape.

9. The power generation element according to any one of claims 1 to 8, wherein
the first electrode portion provided on the first substrate portion has a high wettability to the intermediate portion compared with the first principal surface of the first substrate portion.

10. The power generation element according to any one of claims 1 to 9, wherein
the first joint surface includes:
a first substrate joint surface in contact with the second joint surface; and
a first electrode joint surface in contact with the second electrode portion provided on the second substrate portion, and
the second joint surface includes:
a second substrate joint surface in contact with the first substrate joint surface; and
a second electrode joint surface in contact with the first electrode portion provided on the first substrate portion.

11. The power generation element according to any one of claims 1 to 10, wherein
the first separated surface includes:
a contact surface in contact with the first electrode portion;
a first surface having a portion provided outside the contact surface; and
a second surface provided outside the first surface, wherein
the first surface has a high wettability to the intermediate portion compared with the second surface.

12. The power generation element according to any one of claims 1 to 11, further comprising
a sealing portion provided between the first electrode portion provided on the first substrate portion and the first joint surface and between the second electrode portion provided on the second substrate portion and the second joint surface, the sealing portion surrounding the intermediate portion.

13. The power generation element according to any one of claims 1 to 12, further comprising
a protective film at least surrounding a side surface of the first substrate portion and a side surface of the second substrate portion.

14. A power generation device comprising
a power generation element that converts a thermal energy into an electric energy, wherein
the power generation element includes:
a substrate including mutually opposed first principal surface and second principal surface;
an electrode portion provided on the first principal surface and the second principal surface, the electrode portion including a first electrode portion and a second electrode portion, the second electrode portion having a work function different from a work function of the first electrode portion; and
an intermediate portion including nanoparticles having a work function between the work function of the first electrode portion and the work function of the second electrode portion, wherein
the substrate includes a first substrate portion and a second substrate portion that are mutually overlapped viewed in a first direction intersecting with the first principal surface and the second principal surface,
the intermediate portion is sandwiched between the first electrode portion provided on the first principal surface of the first substrate portion and the second electrode portion provided on the second principal surface of the second substrate portion,
the first principal surface of the first substrate portion includes:
a first separated surface that is in contact with the first electrode portion provided on the first substrate portion and separated from the second substrate portion; and
a first joint surface that is provided to be continuous with the first separated surface, separated from the first electrode portion provided on the first substrate portion, and in contact with the second substrate portion, and
the second principal surface of the second substrate portion includes:
a second separated surface that is in contact with the second electrode portion provided on the second substrate portion and separated from the first substrate portion; and
a second joint surface that is provided to be continuous with the second separated surface, separated from the second electrode portion provided on the second substrate portion, and in contact with the first substrate portion.

15. An electronic apparatus comprising:
a power generation element that converts a thermal energy into an electric energy; and
an electronic apparatus configured to be driven using the power generation element as a power supply, wherein
the power generation element includes:
a substrate including mutually opposed first principal surface and second principal surface;
an electrode portion provided on the first principal surface and the second principal surface, the electrode portion including a first electrode portion and a second electrode portion, the second electrode portion having a work function different from a work function of the first electrode portion; and
an intermediate portion including nanoparticles having a work function between the work function of the first electrode portion and the work function of the second electrode portion, wherein
the substrate includes a first substrate portion and a second substrate portion that are mutually overlapped viewed in a first direction intersecting with the first principal surface and the second principal surface,
the intermediate portion is sandwiched between the first electrode portion provided on the first principal surface of the first substrate portion and the second electrode portion provided on the second principal surface of the second substrate portion,
the first principal surface of the first substrate portion includes:
a first separated surface that is in contact with the first electrode portion provided on the first substrate portion and separated from the second substrate portion; and
a first joint surface that is provided to be continuous with the first separated surface, separated from the first electrode portion provided on the first substrate portion, and in contact with the second substrate portion, and
the second principal surface of the second substrate portion includes:
a second separated surface that is in contact with the second electrode portion provided on the second substrate portion and separated from the first substrate portion; and
a second joint surface that is provided to be continuous with the second separated surface, separated from the second electrode portion provided on the second substrate portion, and in contact with the first substrate portion.

16. A method for manufacturing a power generation element that converts a thermal energy into an electric energy, the method comprising:
a first electrode portion formation step of forming a first electrode portion on at least any of a first principal surface of a substrate and a second principal surface opposing the first principal surface;
a second electrode portion formation step of forming a second electrode portion on at least any of the first principal surface and the second principal surface, the second electrode portion having a work function different from a work function of the first electrode portion;
an intermediate portion formation step of forming an intermediate portion including nanoparticles on the first electrode portion formed on the first principal surface of a first substrate portion included in the substrate, the nanoparticles having a work function between the work function of the first electrode portion and the work function of the second electrode portion; and
a joining step of joining the first electrode portion formed on the first principal surface of the first substrate portion and the second electrode portion formed on the second principal surface of a second substrate portion included in the substrate such that the first electrode portion and the second electrode portion are overlapped viewed in a first direction intersecting with the first principal surface and the second principal surface, wherein
after the joining step,
the first principal surface of the first substrate portion includes:
a first separated surface that is in contact with the first electrode portion formed on the first substrate portion and separated from the second substrate portion; and
a first joint surface that is formed to be continuous with the first separated surface, separated from the first electrode portion formed on the first substrate portion, and in contact with the second substrate portion, and
the second principal surface of the second substrate portion includes:
a second separated surface that is in contact with the second electrode portion formed on the second substrate portion and separated from the first substrate portion; and
a second joint surface that is formed to be continuous with the second separated surface, separated from the second electrode portion formed on the second substrate portion, and in contact with the first substrate portion.

17. The method for manufacturing a power generation element according to claim 16, further comprising
a surface treatment step of performing a surface treatment to the first principal surface positioned in a peripheral area of the first electrode portion formed on the first substrate portion before the intermediate portion formation step and the joining step.

18. The method for manufacturing a power generation element according to claim 16 or 17, wherein
the joining step is performed in a state where a pressure between the first substrate portion and the second substrate portion is reduced.
